# EUROPEAN PATENT APPLICATION

(11) **EP 4 675 227 A1**
(43) Date of publication of application: **07.01.2026**
(21) Application number: 25185530.0
(22) Date of filing: 26.06.2025
(51) Int. Cl.: G01C 19/5776, G01P 15/097, G01P 15/00, G01D 3/08

(54) **PHYSICAL QUANTITY DETECTION CIRCUIT AND PHYSICAL QUANTITY DETECTION DEVICE**

(30) Priority: 01.07.2024 JP 2024106112
(71) Applicant: Seiko Epson Corporation, Tokyo 160-8801 (JP)
(72) Inventor: ICHINOSE, Kaoru, Suwa-shi, Nagano 392-8502 (JP); HANEDA, Hideo, Suwa-shi, Nagano 392-8502 (JP); MURASHIMA, Noriyuki, Suwa-shi, Nagano 392-8502 (JP); TAKAHASHI, Tomoaki, Suwa-shi, Nagano 392-8502 (JP)
(74) Representative: MERH-IP Matias Erny Reichl Hoffmann Patentanwälte PartG mbB

(57) **Abstract**

A physical quantity detection circuit includes: a physical quantity detection signal output circuit that includes an amplifier circuit that amplifies a signal output from a physical quantity detection element, and outputs a physical quantity detection signal corresponding to a physical quantity; a failure diagnosis signal output circuit that outputs a failure diagnosis signal based on a signal output from at least one of a plurality of amplifiers included in the amplifier circuit; a failure diagnosis circuit that performs failure diagnosis based on the failure diagnosis signal and outputs a failure flag indicating a result of the failure diagnosis; a mask signal output circuit that compares a level of a signal output from each of the plurality of amplifiers with each of a plurality of set detection levels and outputs a mask signal based on a result of the comparison; and a disabling determination circuit that disables the failure flag based on the mask signal.

## Description

The present application is based on, and claims priority from JP Application Serial Number 2024-106112, filed July 1, 2024, the disclosure of which is hereby incorporated by reference herein in its entirety.

### BACKGROUND

### 1. Technical Field

The present disclosure relates to a physical quantity detection circuit and a physical quantity detection device.

### 2. Related Art

Currently, in various systems and electronic apparatuses, physical quantity detection devices capable of detecting various physical quantities, such as a gyro sensor for detecting an angular velocity and an acceleration sensor for detecting an acceleration, are used. In recent years, in order to achieve high reliability in a system using a physical quantity detection device, a method of diagnosing whether or not a failure has occurred in the physical quantity detection device has been proposed.

For example, JP-A-2023-140589 describes a physical quantity detection device that diagnoses a failure in parallel with detection of a physical quantity. In the physical quantity detection device described in JP-A-2023-140589, a physical quantity detection circuit generates a physical quantity detection signal by performing synchronous detection after differentially amplifying first and second physical quantity components of opposite phases generated in two detection electrodes due to flexural vibration of two detection vibration arms when a physical quantity is applied in a state where a drive signal is applied to a drive electrode of a physical quantity detection element to bend and vibrate the two drive vibration arms. Further, the physical quantity detection circuit sums first and second electrostatic leakage components having the same phase and propagated from the drive electrode to the two detection electrodes through first and second electrostatic coupling capacitances, then performs synchronous detection, generates an electrostatic leakage signal, and performs failure diagnose based on a vibration leakage signal. According to the physical quantity detection device described in JP-A-2023-140589, when wiring coupling the physical quantity detection element and the physical quantity detection circuit is decoupled, the magnitude of the electrostatic leakage signal deviates from a predetermined range, and thus it is possible to diagnose that a failure has occurred.

However, in the existing physical quantity detection device, when resonance occurs in the physical quantity detection element due to application of mechanical impact, vibration, or the like, an abnormal signal is temporarily input to the physical quantity detection circuit, and even when the physical quantity detection device does not actually fail, the physical quantity detection device may be erroneously diagnosed as failing.

### SUMMARY

According to an aspect of the present disclosure, a physical quantity detection circuit includes: a physical quantity detection signal output circuit that includes an amplifier circuit that amplifies a signal output from a physical quantity detection element that detects a physical quantity, and outputs a physical quantity detection signal corresponding to the physical quantity; a failure diagnosis signal output circuit that outputs a failure diagnosis signal based on a signal output from at least one of a plurality of amplifiers included in the amplifier circuit; a failure diagnosis circuit that performs failure diagnosis based on the failure diagnosis signal and outputs a failure flag indicating a result of the failure diagnosis, a mask signal output circuit that compares a level of a signal output from each of the plurality of amplifiers with each of a plurality of set detection levels and outputs a mask signal based on a result of the comparison, and a disabling determination circuit that disables the failure flag based on the mask signal.

According to another aspect of the present disclosure, a physical quantity detection device includes: a semiconductor device including the physical quantity detection circuit; the physical quantity detection element; and a package housing the physical quantity detection element and the semiconductor device.

### BRIEF DESCRIPTION OF THE DRAWINGS

FIG. 1 is a functional block diagram of a physical quantity detection device.
FIG. 2 is a plan view of a vibrator element of a physical quantity detection element.
FIG. 3 is a diagram illustrating an example of a configuration of a drive circuit.
FIG. 4 is a diagram illustrating an example of a configuration of a detection circuit.
FIG. 5 is a diagram illustrating an example of waveforms of various signals with respect to physical quantity components.
FIG. 6 is a diagram illustrating an example of waveforms of various signals with respect to electrostatic leakage components.
FIG. 7 is a diagram illustrating an example of waveforms of various signals with respect to vibration leakage components.
FIG. 8 is a diagram illustrating an example of a configuration of a mask signal output circuit.
FIG. 9 is a diagram illustrating an example of correspondence between logic levels of comparison result signals and logic levels of a mask signal.
FIG. 10 is a diagram illustrating an example of waveforms of various signals with respect to an abnormal signal.
FIG. 11 is a diagram illustrating an example of waveforms of the various signals with respect to an abnormal signal.
FIG. 12 is a diagram illustrating an example of waveforms of the various signals with respect to an abnormal signal.
FIG. 13 is a diagram illustrating an example of waveforms of various signals with respect to an abnormal signal.

### DESCRIPTION OF EMBODIMENTS

Hereinafter, preferred embodiments of the present disclosure will be described in detail with reference to the drawings. It should be noted that the embodiments described below do not unduly limit the contents of the present disclosure described in the appended claims. In addition, all of the configurations described below are not necessarily essential components of the present disclosure.

A physical quantity detection device that detects an angular velocity as a physical quantity, that is, an angular velocity detection device will be described below as an example.

### 1. Configuration of Physical Quantity Detection Device

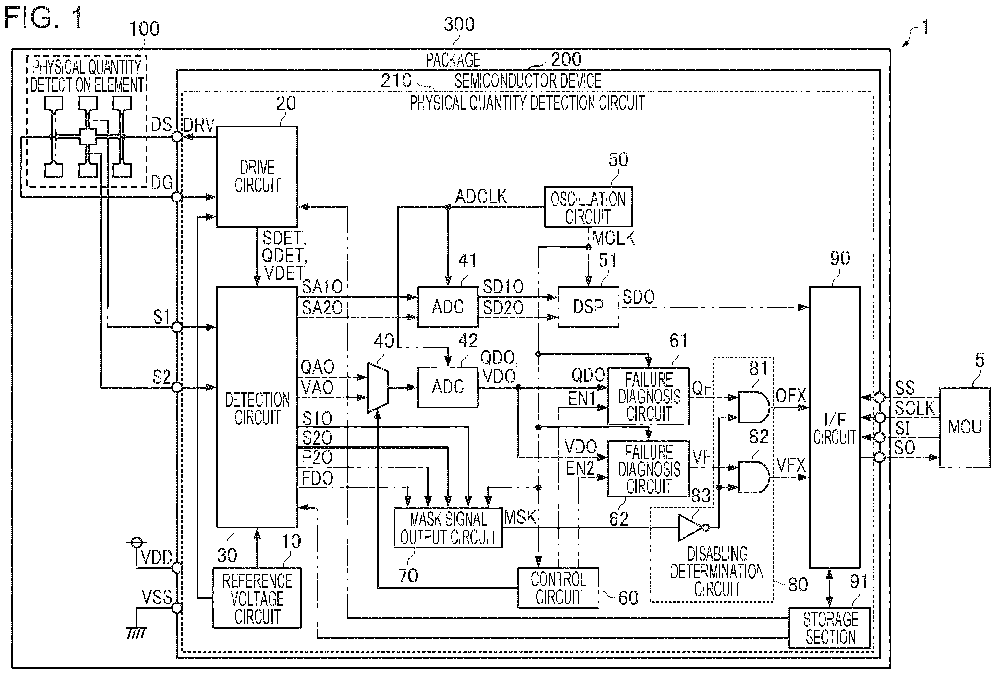

FIG. 1 is a functional block diagram of a physical quantity detection device according to the present embodiment. As illustrated in FIG. 1, the physical quantity detection device 1 according to the present embodiment includes a physical quantity detection element 100 that detects a physical quantity, a semiconductor device 200 including a physical quantity detection circuit 210, and a package 300 housing the physical quantity detection element 100 and the semiconductor device 200. The semiconductor device 200 is implemented as, for example, a one-chip integrated circuit. The package 300 is, for example, a ceramic package.

The physical quantity detection element 100 includes a vibrator element in which drive electrodes and detection electrodes are disposed. In general, the vibrator element is sealed in a package in which airtightness is secured in order to increase oscillation efficiency by reducing the impedance of the vibrator element as much as possible. In the present embodiment, the physical quantity detection element 100 includes, as the vibrator element, a so-called double T-shaped vibrator element having two T-shaped drive vibration arms.

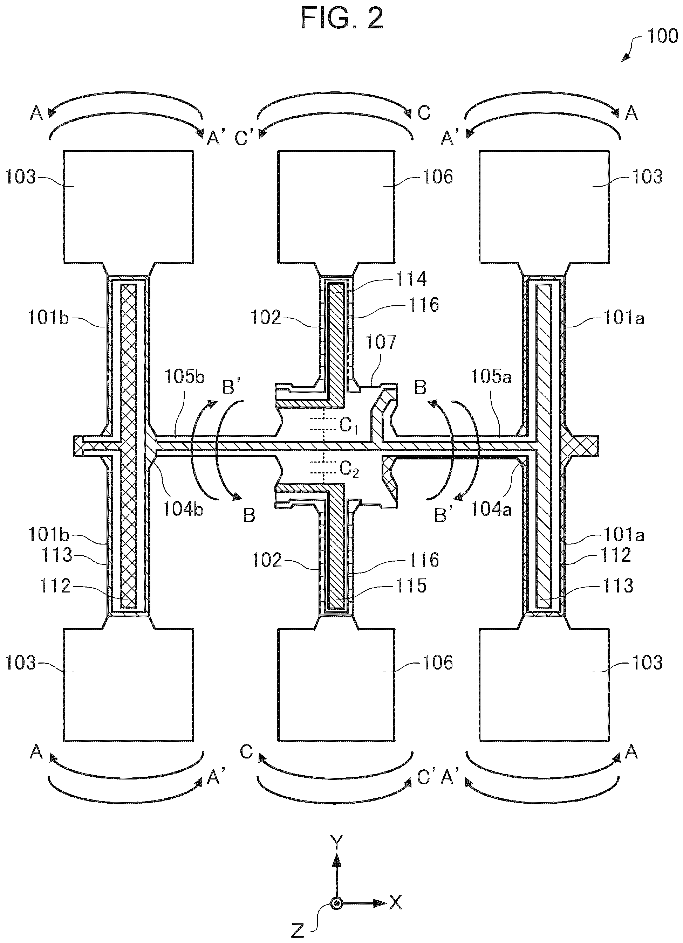

FIG. 2 is a plan view of the vibrator element of the physical quantity detection element 100 according to the present embodiment. The physical quantity detection element 100 includes, for example, the double T-shaped vibrator element formed of a Z-cut quartz crystal substrate. The vibrator element made of quartz crystal has an advantage that the accuracy of detecting an angular velocity can be improved because a resonance frequency does not change much with a change in the temperature. Note that an X axis, a Y axis, and a Z axis in FIG. 2 indicate axes of the crystal.

As illustrated in FIG. 2, in the vibrator element of the physical quantity detection element 100, the drive vibration arms 101a and 101b extend from two drive base portions 104a and 104b, respectively, in a +Y axis direction and a -Y axis direction. The drive electrodes 112 and 113 are formed on a side surface and an upper surface of the drive vibration arm 101a, respectively. The drive electrodes 113 and 112 are formed on a side surface and an upper surface of the drive vibration arm 101b, respectively. The drive electrode 112 is coupled to a DG terminal of the semiconductor device 200 illustrated in FIG. 1 via wiring (not illustrated), and the drive electrode 113 is coupled to a DS terminal of the semiconductor device 200 illustrated in FIG. 1 via wiring (not illustrated).

The drive base portions 104a and 104b are coupled to a rectangular detection base portion 107 via coupling arms 105a and 105b extending in a -X axis direction and a +X axis direction, respectively.

Detection vibration arms 102 extend from the detection base portion 107 in the +Y axis direction and the -Y axis direction. The detection electrodes 114 and 115 are formed on upper surfaces of the detection vibration arms 102, and a common electrode 116 is formed on side surfaces of the detection vibration arms 102. The detection electrodes 114 and 115 are coupled to a detection circuit 30 via an S1 terminal and an S2 terminal of the semiconductor device 200 illustrated in FIG. 1. The common electrode 116 is grounded.

When an alternating-current voltage is applied as a drive signal DRV between the drive electrodes 112 and 113 of the drive vibration arms 101A and 101b, distal ends of the two drive vibration arms 101a and 101b perform flexural vibration in which the distal ends repeatedly approach and move away from each other in an A direction and an A' direction due to an inverse piezoelectric effect. Hereinafter, the flexural vibration of the drive vibration arms 101a and 101b may be also referred to as "excitation vibration".

In this state, when an angular velocity with the Z axis as a rotational axis is applied to the vibrator element of the physical quantity detection element 100, the drive vibration arms 101a and 101b obtain a Coriolis force in a direction orthogonal to both a direction of the flexural vibration and the Z axis. As a result, the two coupling arms 105a and 105B vibrate in a B direction and a B' direction which are opposite to each other. In this case, the two detection vibration arms 102 attempt to maintain balance, and thus perform flexural vibration in a C direction and a C' direction which are opposite to each other. The phase of the flexural vibration of each of the detection vibration arms 102 due to the Coriolis force is shifted by 90° from the phase of the flexural vibration of each of the drive vibration arms 101a and 101b due to the Coriolis force.

Then, alternating-current electrical charges based on these flexural vibrations are generated in the detection electrodes 114 and 115 of the detection vibration arms 102 due to a piezoelectric effect. In this case, the alternating-current electrical charges generated based on the Coriolis force vary depending on the magnitude of the Coriolis force, that is, the magnitude of the angular velocity applied to the physical quantity detection element 100.

Rectangular weight portions 103 that are wider than the drive vibration arms 101a and 101b are formed at the distal ends of the drive vibration arms 101a and 101b. Since the weight portions 103 are formed at the distal ends of the drive vibration arms 101a and 101b, the Coriolis force can be increased and a desired resonance frequency can be obtained with the relatively short vibration arms. Similarly, weight portions 106 that are wider than the detection vibration arms 102 are formed at distal ends of the detection vibration arms 102. Since the weight portions 106 are formed at the distal ends of the detection vibration arms 102, it is possible to increase amounts of alternating-current electrical charges generated in the detection electrodes 114 and 115.

Note that alternating-current frequency components included in the drive signal DRV supplied to the drive electrode 113 propagate to the detection electrodes 114 and 115 through a first electrostatic coupling capacitance C₁ present between the drive electrode 113 and the detection electrode 114 and a second electrostatic coupling capacitance C₂ present between the drive electrode 113 and the detection electrode 115, and alternating-current electrical charges based on the alternating-frequency components are generated, but the alternating-current electrical charges are not erroneously detected as an angular velocity.

When the magnitudes of the energy of the vibration or the magnitudes of the amplitudes of the vibration when the drive vibration arms 101a and 101b perform the flexural vibration are equal to each other in the two drive vibration arms 101a and 101b, the vibration energy of the drive vibration arm 101a and the vibration energy of the drive vibration arm 101b are balanced, and the detection vibration arms 102 do not perform flexural vibration in a state where the angular velocity is not applied to the physical quantity detection element 100. However, when the balance of the vibration energy of the two drive vibration arms 101a and 101b is lost, flexural vibration occurs in the detection vibration arms 102 even in a state where the angular velocity is not applied to the physical quantity detection element 100. This flexural vibration is referred to as leakage vibration and is flexural vibration in the C direction and the C' direction similarly to the vibration based on the Coriolis force, and alternating-current electrical charges based on the leakage vibration are generated in the detection electrodes 114 and 115. Since the phase of the leakage vibration is shifted by 90° from the phase of the vibration based on the Coriolis force, as will be described later, an alternating-current electrical charge is not erroneously detected as an angular velocity. However, in order to improve the accuracy of detecting an angular velocity, it is preferable that the leakage vibration not occur.

For example, by tuning the weights of the four weight portions 103 such that the vibration energy of two portions of the drive vibration arm 101a is equal, the vibration energy of two portions of the drive vibration arm 101b is equal, and the sum of the vibration energy of the two portions of the drive vibration arm 101a and the sum of the vibration energy of the two portions of the drive vibration arm 101b are equal, it is possible to make the leakage vibration hardly occur. The weights of the weight portions 103 can be tuned by, for example, irradiating the weight portions 103 with a laser beam to cut portions of the weight portions 103. When the physical quantity detection element 100 is normal, the leakage vibration almost does not occur. However, if the physical quantity detection element 100 fails, for example, if a crack or the like occurs in at least one of the drive vibration arms 101a and 101b and the detection vibration arms 102, the balance of the vibration energy of the drive vibration arms 101a and 101b is lost, and the leakage vibration occurs. Therefore, if the physical quantity detection element 100 fails, the physical quantity detection element 100 outputs alternating-current electrical charges based on the leakage vibration from the detection electrodes 114 and 115.

As described above, the physical quantity detection element 100 is a double-T type gyro sensor element, and outputs, from the detection electrodes 114 and 115, alternating-current electrical charges based on the detected physical quantity, alternating-current electrical charges based on the drive signal DRV propagated through the first electrostatic coupling capacitance C₁ and the second electrostatic coupling capacitance C₂, and alternating-current electrical charges based on the leakage vibration. Hereinafter, the alternating-current electrical charges based on the physical quantity may be referred to as "physical quantity components", the alternating-current electrical charges based on the drive signal DRV propagated through the first electrostatic coupling capacitance C₁ and the second electrostatic coupling capacitance C₂ may be referred to as "electrostatic leakage components", and the alternating-current electrical charges based on the leakage vibration may be referred to as "vibration leakage components". In the present embodiment, the physical quantity detected by the physical quantity detection element 100 is the angular velocity corresponding to the Coriolis force.

Returning to the description of FIG. 1, the physical quantity detection circuit 210 includes a reference voltage circuit 10, a drive circuit 20, the detection circuit 30, a selector 40, an analog-to-digital conversion circuit 41, an analog-to-digital conversion circuit 42, an oscillation circuit 50, a digital signal processing circuit 51, a control circuit 60, a failure diagnosis circuit 61, a failure diagnosis circuit 62, a mask signal output circuit 70, a disabling determination circuit 80, an interface circuit 90, and a storage section 91. The physical quantity detection circuit 210 may have a configuration in which some of these elements are omitted or changed, or other elements are additionally provided.

The reference voltage circuit 10 generates a constant voltage such as a reference voltage which is an analog ground voltage or a constant current based on a power supply voltage and a ground voltage supplied from a VDD terminal and a VSS terminal of the semiconductor device 200, respectively, and supplies the constant voltage or the constant current to the drive circuit 20 and the detection circuit 30.

The drive circuit 20 applies the drive signal DRV including a first frequency component for driving the physical quantity detection element 100 to the drive electrode 113 of the physical quantity detection element 100 through the DS terminal. The physical quantity detection element 100 is excited and vibrated by the drive signal DRV. In addition, an oscillation current generated in the drive electrode 112 due to the excitation vibration of the physical quantity detection element 100 is input to the drive circuit 20 through the DG terminal, and the drive circuit 20 performs feedback control of the amplitude level of the drive signal DRV such that the amplitude of the oscillation current is kept constant. The drive circuit 20 generates a detection signal SDET having the same phase as the drive signal DRV, a detection signal QDET at a frequency twice the frequency of the detection signal SDET, and a detection signal VDET having a phase different from the phase of the drive signal DRV by 90°, and outputs the detection signals SDET, QDET, and VDET to the detection circuit 30. The detection signal SDET is an example of a "first detection signal", the detection signal QDET is an example of a "second detection signal", and the detection signal VDET is an example of a "third detection signal".

The detection circuit 30 outputs the physical quantity detection signal SA1O and SA2O corresponding to the physical quantity detected by the physical quantity detection element 100 based on a first physical quantity component included in a first signal output from the detection electrode 114 of the physical quantity detection element 100 and a second physical quantity component included in a second signal output from the detection electrode 115 of the physical quantity detection element 100. The first signal is an alternating-current electrical charge input to the detection circuit 30 through the S1 terminal of the semiconductor element 200, and the second signal is an alternating-current electrical charge input to the detection circuit 30 through the S2 terminal of the semiconductor element 200. The detection circuit 30 detects physical quantity components based on the first physical quantity component included in the first signal and the second physical quantity component included in the second signal using the detection signal SDET, and generates and outputs physical quantity detection signals SA1O and SA2O which are analog signals at voltage levels corresponding to the magnitudes of the detected physical quantity components. The detection electrode 114 is an example of a "first detection electrode", and the detection electrode 115 is an example of a "second detection electrode".

Further, the detection circuit 30 outputs an electrostatic leakage detection signal QAO based on a first electrostatic leakage component included in the first signal and a second electrostatic leakage component included in the second signal. The drive signal DRV output from the drive circuit 20 includes a second frequency component at a frequency different from the frequency of the first frequency component, and the first electrostatic leakage component is a component of the second frequency component propagated to the detection electrode 114 through the first electrostatic coupling capacitance C₁ present between the drive electrode 113 and the detection electrode 114 of the physical quantity detection element 100. Similarly, the second electrostatic leakage component is a component of the second frequency component propagated to the detection electrode 115 through the second electrostatic coupling capacitance C₂ present between the drive electrode 113 and the detection electrode 115 of the physical quantity detection element 100. In the present embodiment, the frequency of the second frequency component is twice the frequency of the first frequency component, and the second frequency component is generated when the drive circuit 20 generates the drive signal DRV, as will be described later. The detection circuit 30 detects an electrostatic leakage component based on the first electrostatic leakage component included in the first signal and the second electrostatic leakage component included in the second signal using the detection signal QDET, and generates and outputs an electrostatic leakage detection signal QAO which is an analog signal at a voltage level corresponding to the magnitude of the detected electrostatic leakage component.

Further, the detection circuit 30 outputs a vibration leakage detection signal VAO based on a first vibration leakage component included in the first signal output from the detection electrode 114 of the physical quantity detection element 100 and a second vibration leakage component included in the second signal output from the detection electrode 115 of the physical quantity detection element 100. The first vibration leakage component and the second vibration leakage component are components based on the vibration of the physical quantity detection element 100. As described above, when the physical quantity detection element 100 is normal, the leakage vibration hardly occurs, and thus the first signal hardly includes the first vibration leakage component, and the second signal hardly includes the second vibration leakage component. On the other hand, if the physical quantity detection element 100 fails, the leakage vibration occurs, and thus the first signal includes the first vibration leakage component and the second signal includes the second vibration leakage component. The detection circuit 30 detects a vibration leakage component based on the first vibration leakage component included in the first signal and the second vibration leakage component included in the second signal using the detection signal VDET, and generates and outputs the vibration leakage detection signal VAO which is an analog signal at a voltage level corresponding to the magnitude of the detected vibration leakage component.

The storage section 91 includes a nonvolatile memory (not illustrated), and the nonvolatile memory stores various types of trimming data for the drive circuit 20 and the detection circuit 30. The nonvolatile memory may be configured as, for example, a MONOS type memory or an EEPROM. MONOS is an abbreviation for Metal Oxide Nitride Oxide Silicon. EEPROM is an abbreviation of Electrically Erasable Programmable Read-Only Memory. Further, the storage section 91 may include a register (not illustrated), and may be configured such that, when the semiconductor integrated circuit device 200 is powered on, that is, when the voltage of the VDD terminal rises from 0 V to a desired voltage, the various types of trimming data stored in the nonvolatile memory are transferred to and held in the register, and the various types of trimming data held in the register are supplied to the drive circuit 20 and the detection circuit 30.

The oscillation circuit 50 generates a master clock signal MCLK and supplies the master clock signal MCLK to the digital signal processing circuit 51 and the failure diagnosis circuits 61 and 62. In addition, the oscillation circuit 50 divides the frequency of the master clock signal MCLK to generate a clock signal ADCLK, and supplies the clock signal ADCLK to the analog-to-digital conversion circuits 41 and 42. The oscillation circuit 50 may generate the master clock signal MCLK by using, for example, a ring oscillator or a CR oscillation circuit.

The selector 40 selects the electrostatic leakage detection signal QAO and the vibration leakage detection signal VAO in a time-division manner according to a control signal output from the control circuit 60 and outputs the selected signals to the analog-to-digital conversion circuit 42.

The analog-to-digital conversion circuit 41 operates based on the clock signal ADCLK, converts the physical quantity detection signals SA1O and SA2O, which are analog signals output from the detection circuit 30, into physical quantity detection signals SD1O and SD2O, which are digital signals, respectively, and outputs the physical quantity detection signals SD1O and SD2O.

The analog-to-digital conversion circuit 42 operates based on the clock signal ADCLK, converts the electrostatic leakage detection signal QAO and the vibration leakage detection signal VAO, which are analog signals output from the selector 40 in a time-division manner, into an electrostatic leakage detection signal QDO and a vibration leakage detection signal VDO, which are digital signals, respectively, and outputs the electrostatic leakage detection signal QDO and the vibration leakage detection signal VDO.

The digital signal processing circuit 51 operates based on the master clock signal MCLK, performs predetermined calculation processing such as difference calculation on the physical quantity detection signals SD1O and SD2O output from the analog-to-digital conversion circuit 41, and outputs a physical quantity detection signal SDO obtained by the calculation processing.

The failure diagnosis circuit 61 operates based on the master clock signal MCLK, and performs failure diagnosis on the physical quantity detection device 1 based on the electrostatic leakage detection signal QDO. Then, the failure diagnosis circuit 61 outputs a failure flag QF indicating whether or not the physical quantity detection device 1 has failed. In the physical quantity detection device 1, since the alternating-current electrical charges based on the drive signal DRV propagated to the detection electrodes 114 and 115 through the first electrostatic coupling capacitance C₁ and the second electrostatic coupling capacitance C₂ are constant, the value of the electrostatic leakage detection signal QDO is in a predetermined first range when both of wiring coupling the detection electrode 114 to the S1 terminal of the semiconductor element 200 and wiring coupling the detection electrode 115 to the S2 terminal of the semiconductor element 200 are normal. On the other hand, when at least one of the wiring coupling the detection electrode 114 to the S1 terminal and the wiring coupling the detection electrode 115 to the S2 terminal is decoupled, the value of the electrostatic leakage detection signal QDO deviates from the first range. Therefore, the failure diagnosis circuit 61 may diagnose that the physical quantity detection device 1 has failed when the value of the electrostatic leakage detection signal QDO is not in the first range. For example, the first range may be set to include a predetermined value which is assumed in design when the physical quantity detection device 1 is normal, and to include a range that may change from the predetermined value over time. In addition, the first range may be fixed or may be variable. For example, the first range may be variably set in accordance with a value stored in a register which is included in the storage section 91 and is rewritable from the outside of the semiconductor device 200.

The failure diagnosis circuit 62 operates based on the master clock signal MCLK and performs failure diagnosis on the physical quantity detection device 1 based on the vibration leakage detection signal VDO. Then, the failure diagnosis circuit 62 outputs a failure flag VF indicating whether or not the physical quantity detection device 1 has failed. When the physical quantity detection device 1 is normal, the leakage vibration hardly occurs, and thus the value of the vibration leakage detection signal VDO is in a predetermined second range. On the other hand, for example, if the physical quantity detection element 100 fails, for example, a portion of the physical quantity detection element 100 is broken, the leakage vibration occurs, and thus the value of the vibration leakage detection signal VDO deviates from the second range. Therefore, the failure diagnosis circuit 62 may diagnose that the physical quantity detection device 1 has failed when the value of the vibration leakage detection signal VDO is not in the second range. For example, the second range may be set to include a predetermined value which is assumed in design when the physical quantity detection device 1 is normal, and to include a range which may change from the predetermined value over time. In addition, the second range may be fixed or may be variable. For example, the second range may be variably set in accordance with a value stored in a register which is included in the storage section 91 and is rewritable from the outside of the semiconductor device 200.

The mask signal output circuit 70 operates based on the master clock signal MCLK, and generates and outputs a mask signal MSK based on logic levels of signals S1O, S2O, P2O, and FDO which are internal signals of the detection circuit 30. The signals S1O, S2O, P2O, and FDO and the mask signal MSK will be described later in detail.

The disabling determination circuit 80 includes an AND circuit 81, an AND circuit 82, and a NOT circuit 83, and disables the failure flags QF and VF based on the mask signal MSK. The NOT circuit 83 outputs a signal obtained by inverting the logic level of the mask signal MSK. The AND circuit 81 receives the failure flag QF and a signal output from the NOT circuit 83, and outputs a failure diagnosis result signal QFX. Specifically, the AND circuit 81 outputs the failure flag QF as the failure diagnosis result signal QFX when the signal output from the NOT circuit 83 is at a high level, and outputs a low-level signal as the failure diagnosis result signal QFX when the signal output from the NOT circuit 83 is at a low level.

The AND circuit 82 receives the failure flag VF and the signal output from the NOT circuit 83, and outputs a failure diagnosis result signal VFX. Specifically, the AND circuit 82 outputs the failure flag VF as the failure diagnosis result signal VFX when the signal output from the NOT circuit 83 is at a high level, and outputs a low-level signal as the failure diagnosis result signal VFX when the signal output from the NOT circuit 83 is at a low level.

Therefore, the disabling determination circuit 80 outputs the failure flags QF and VF as the failure diagnosis result signals QFX and VFX, respectively, when the mask signal MSK is at a low level, and outputs the low-level signals as the failure diagnosis result signals QFX and VFX when the mask signal MSK is at a high level. As described above, the disabling determination circuit 80 disables the failure flags QF and VF when the mask signal MSK at a high level is input to the disabling determination circuit 80.

The control circuit 60 operates based on the master clock signal MCLK, and generates a control signal for controlling the operation of the selector 40 and enable signals EN1 and EN2 for operating the respective failure diagnosis circuits 61 and 62. Specifically, the control circuit 60 causes the failure diagnosis circuit 61 to operate by activating the enable signal EN1 only in a period of time when the analog-to-digital conversion circuit 42 outputs the electrostatic leakage detection signal QDO, and causes the failure diagnosis circuit 62 to operate by activating the enable signal EN2 only in a period of time when the analog-to-digital conversion circuit 42 outputs the vibration leakage detection signal VDO.

The interface circuit 90 performs a process of outputting, to a MCU 5, the physical quantity detection signal SDO output from the digital signal processing circuit 51, the failure flags QF and VF, and the like in response to a request from the MCU 5 which is an external device of the semiconductor device 200. MCU is an abbreviation for Micro Control Unit. The interface circuit 90 may perform a process of outputting, to the MCU 5, the electrostatic leakage detection signal QDO and the vibration leakage detection signal VDO output from the analog-to-digital conversion circuit 42 in response to a request from the MCU 5. In this case, the physical quantity detection circuit 210 may not include the failure diagnosis circuits 61 and 62, and the MCU 5 may perform the same failure diagnosis as that performed by the failure diagnosis circuits 61 and 62, based on the electrostatic leakage detection signal QDO and the vibration leakage detection signal VDO.

In response to a request from the MCU 5, the interface circuit 90 performs a process of reading data stored in the non-volatile memory and the registers of the storage section 91 and outputting the data to the MCU 5, and a process of writing data input from the MCU 5 to the non-volatile memory and the registers of the storage section 91. For example, the MCU 5 may perform a process of writing, to a predetermined register, values for setting the first range and the second range described above.

The interface circuit 90 is, for example, an interface circuit of an SPI bus, receives a selection signal, a clock signal, and a data signal transmitted from the MCU 5 through an SS terminal, an SCLK terminal, and an SI terminal of the semiconductor device 200, respectively, and outputs the data signal to the MCU 5 through an SO terminal of the semiconductor device 200. SPI is an abbreviation for Serial Peripheral Interface. Note that the interface circuit 90 may be an interface circuit corresponding to various buses other than the SPI bus, for example, an I²C bus. I²C Is an abbreviation for Inter-Integrated Circuit.

In the physical quantity detection device 1 configured as described above according to the present embodiment, the physical quantity detection element 100 outputs the first signal which is the alternating-current electrical charge generated in the detection electrode 114 and the second signal which is the alternating-current electrical charge generated in the detection electrode 115, and the physical quantity detection circuit 210 generates the physical quantity detection signal SDO corresponding to the physical quantity detected by the physical quantity detection element 100, based on the first signal and the second signal output from the physical quantity detection element 100. Further, the physical quantity detection circuit 210 generates the failure diagnosis result signals QFX and VFX indicating whether the physical quantity detection device 1 has a failure, based on the first signal and the second signal output from the physical quantity detection element 100.

### 2. Configuration of Drive Circuit

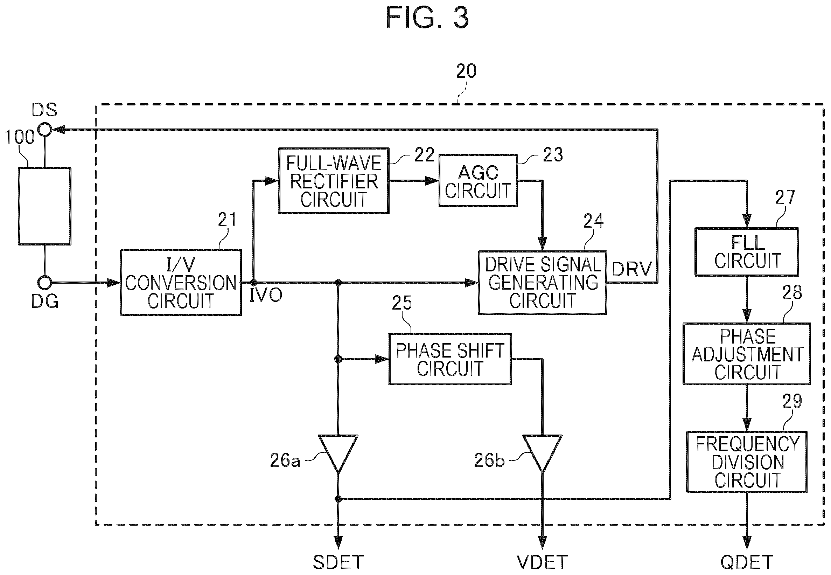

FIG. 3 is a diagram illustrating an example of a configuration of the drive circuit 20. As illustrated in FIG. 3, the drive circuit 20 includes a current-to-voltage conversion circuit 21, a full-wave rectifier circuit 22, an automatic gain control circuit 23, a drive signal generating circuit 24, a phase shift circuit 25, a buffer circuit 26a, a buffer circuit 26b, an FLL circuit 27, a phase adjustment circuit 28, and a frequency division circuit 29.

The oscillation current generated in the drive electrode 112 due to the excitation vibration of the physical quantity detection element 100 is input to the current-to-voltage conversion circuit 21 through the DG terminal, and is converted into an alternating-current voltage signal IVO by the current-to-voltage conversion circuit 21. The alternating-current voltage signal IVO output from the current-to-voltage conversion circuit 21 is input to the full-wave rectifier circuit 22, the drive signal generating circuit 24, the phase shift circuit 25, and the buffer circuit 26a.

The full-wave rectifier circuit 22 performs full-wave rectification on the signal IVO output from the current-to-voltage conversion circuit 21 to form a direct-current signal and outputs the direct-current signal.

The automatic gain control circuit 23 amplifies the signal output from the full-wave rectifier circuit 22 to form a signal having a predetermined voltage and outputs the signal having the predetermined voltage. The automatic gain control circuit 23 controls the gain of amplification in accordance with the magnitude of the signal output from the full-wave rectifier circuit 22 such that the output signal is constant at the predetermined voltage.

The drive signal generating circuit 24 outputs the drive signal DRV obtained by binarizing the signal IVO output from the current-to-voltage conversion circuit 21. The high-level voltage of the drive signal DRV is the voltage of the signal output from the automatic gain control circuit 23, and is constant at the predetermined voltage. The drive signal DRV is supplied to the drive electrode 113 of the physical quantity detection element 100 through the DS terminal. The physical quantity detection element 100 can continue the excitation vibration when the drive signal DRV is supplied to the physical quantity detection element 100. Further, since the high-level voltage of the drive signal DRV is kept constant, the drive vibration arms 101a and 101b of the physical quantity detection element 100 can vibrate at a constant vibration speed. Therefore, the vibration speed which is a source of generating the Coriolis force can be constant, and the sensitivity can be made more stable.

The fundamental frequency of the drive signal DRV generated as described above matches the frequency f of the flexural vibration of each of the drive vibration arms 101a and 101b of the physical quantity detection element 100. In addition, the full-wave rectifier circuit 22 performs full-wave rectification to generate the second frequency component at a frequency 2f, and superimposes the second frequency component on the high-level voltage of the drive signal DRV. Therefore, the drive signal DRV includes the first frequency component at the frequency f and the second frequency component at the frequency 2f.

The phase shift circuit 25 outputs a signal obtained by advancing the phase of the signal IVO output from the current-to-voltage conversion circuit 21 by 90°. The phase shift circuit 25 may be an all-pass filter including an amplifier, a resistor, and a capacitor. The buffer circuit 26a outputs the detection signal SDET having the same phase as the signal IVO. The buffer circuit 26b outputs the detection signal VDET having the same phase as the signal output from the phase shift circuit 25. A filter may be provided between the output of the current-to-voltage conversion circuit 21 and the input of the buffer circuit 26a.

The FLL circuit 27 converts the detection signal SDET into a clock signal VCO at a frequency that is n times higher than that of the detection signal SDET, and outputs the clock signal VCO. FLL is an abbreviation for Frequency Locked Loop. The phase adjustment circuit 28 adjusts the phase of the clock signal VCO output from the FLL circuit 27 such that a rising edge of the clock signal VCO matches a rising edge of the detection signal SDET. The frequency division circuit 29 divides the frequency of the clock signal VCO, and outputs the detection signal QDET at a frequency that is twice the frequency of the detection signal SDET.

The detection signal SDET is a square-wave voltage signal at the frequency f, the detection signal QDET is a square-wave voltage signal at the frequency 2f, and the detection signal VDET is a square-wave voltage signal at the frequency f and with a phase advanced by 90° from the phase of the detection signal SDET. The detection signals SDET, QDET, and VDET are supplied to the detection circuit 30.

### 3. Configuration of Detection Circuit

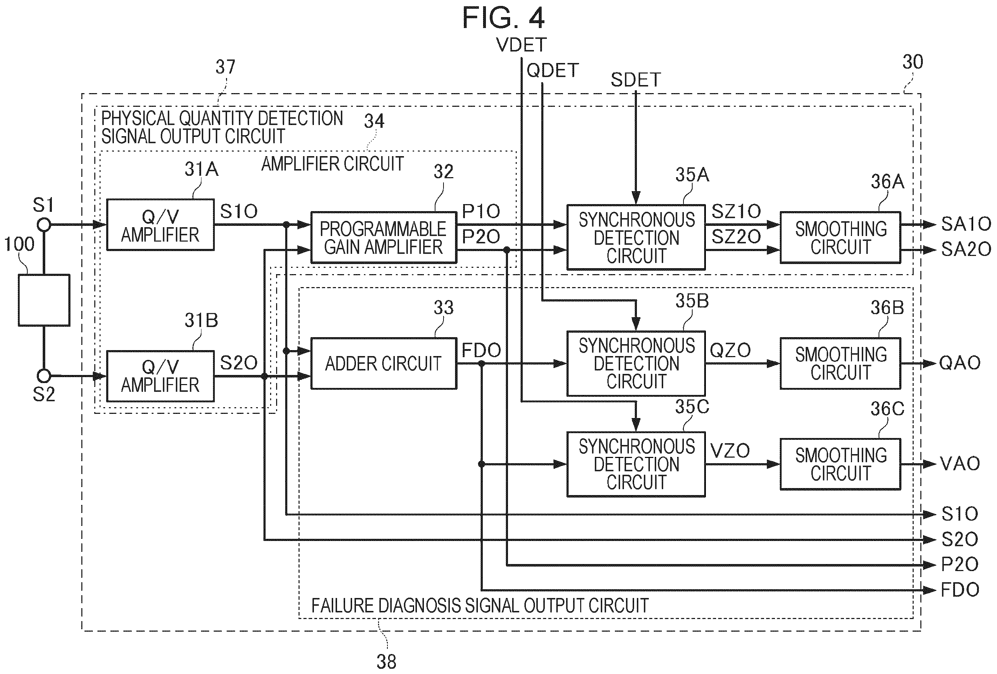

FIG. 4 is a diagram illustrating an example of a configuration of the detection circuit 30. As illustrated in FIG. 4, the detection circuit 30 includes Q/V amplifiers 31A and 31B, a programmable gain amplifier 32, an adder circuit 33, synchronous detection circuits 35A and 35B, and smoothing circuits 36A and 36B.

The first signal is input to the Q/V amplifier 31A through the S1 terminal. As described above, the first signal is the alternating-current electrical charge generated in the detection electrode 114 of the physical quantity detection element 100, and includes the first physical quantity component and the first electrostatic leakage component.

The second signal is input to the Q/V amplifier 31B through the S2 terminal. As described above, the second signal is the alternating-current electrical charge generated in the detection electrode 115 of the physical quantity detection element 100, and includes the second physical quantity component and the second electrostatic leakage component.

In the present embodiment, as illustrated in FIG. 2, when an angular velocity is applied to the physical quantity detection element 100, the detection vibration arm 102 on which the detection electrode 114 is formed and the detection vibration arm 102 on which the detection electrode 115 is formed perform flexural vibration in opposite directions to each other so as to be balanced. Therefore, the first physical quantity component included in the first signal and the second physical quantity component included in the second signal have phases opposite to each other. The case where the first physical quantity component included in the first signal and the second physical quantity component included in the second signal have the phases opposite to each other includes not only a case where the difference between the phases of the two physical quantity components is exactly 180° but also a case where the difference between the phases of the two physical quantity components is slightly different from 180° due to a manufacturing error of the physical quantity detection element 100, an error of a delay time of a signal propagation path, or the like.

In the present embodiment, the phase of the first electrostatic leakage component included in the first signal and the phase of the second electrostatic leakage component included in the second signal are the same. The case where the phase of the first electrostatic leakage component included in the first signal and the phase of the second electrostatic leakage component included in the second signal are the same includes not only a case where the difference between the phases of the two electrostatic leakage components is accurately 0° but also a case where the difference between the phases of the two electrostatic leakage components is slightly different from 0° due to the manufacturing error of the physical quantity detection element 100, the error of the delay time of the signal propagation path, or the like.

If the physical quantity detection element 100 fails, the first signal further includes the first vibration leakage component, and the second signal further includes the second vibration leakage component. In the present embodiment, if the physical quantity detection element 100 fails, the phase of the first vibration leakage component included in the first signal and the phase of the second vibration leakage component included in the second signal are the same. The case where the phase of the first vibration leakage component included in the first signal and the phase of the second vibration leakage component included in the second signal are the same includes not only a case where the difference between the phases of the two vibration leakage components is accurately 0° but also a case where the difference between the phases of the two vibration leakage components is slightly different from 0° due to the manufacturing error of the physical quantity detection element 100, the error of the delay time of the signal propagation path, or the like.

The Q/V amplifier 31A amplifies the first signal input from the detection electrode 114 of the physical quantity detection element 100, and the Q/V amplifier 31B amplifies the second signal input from the detection electrode 115 of the physical quantity detection element 100. Specifically, the Q/V amplifier 31A converts the first signal into the alternating-current voltage signal S1O based on a reference voltage V_{ref} generated by the reference voltage circuit 10 and outputs the alternating-current voltage signal S1O, and the Q/V amplifier 31B converts the second signal into the alternating-current voltage signal S2O based on the reference voltage V_{ref} and outputs the alternating-current voltage signal S2O.

The programmable gain amplifier 32 receives a differential-signal pair including the signal S1O output from the Q/V amplifier 31A and the signal S2O output from the Q/V amplifier 31B, amplifies a difference between the signal S1O output from the Q/V amplifier 31A and the signal S2O output from the Q/V amplifier 31B, and outputs a differential signal pair including signals P1O and P2O.

Since the phase of the first vibration leakage component included in the first signal and the phase of the second vibration leakage component included in the second signal are the same, the vibration leakage components are attenuated by the programmable gain amplifier 32. Therefore, even if the physical quantity detection element 100 fails, the effect of the vibration leakage components on the physical quantity components is minor in the signal output from the programmable gain amplifier 32. In the signal output from the programmable gain amplifier 32, in order to substantially eliminate the effect of the vibration leakage components on the physical quantity components, the amount of the difference between the first vibration leakage component and the second vibration leakage component is preferably substantially zero. The case where the amount of the difference between the first vibration leakage component and the second vibration leakage component is substantially zero includes not only a case where the amount of the difference is exactly zero but also a case where the amount of the difference is slightly different from zero due to the minimum adjustment resolution of the first vibration leakage component and the second vibration leakage component or the like and a case where a measured value of the amount of the difference is slightly different from zero due to a measurement error of the amount of the difference between the first vibration leakage component and the second vibration leakage component.

The synchronous detection circuit 35A performs synchronous detection on the signals P1O and P2O output from the programmable gain amplifier 32. Specifically, the synchronous detection circuit 35A performs synchronous detection on the signals P1O and P2O output from the programmable gain amplifier 32 based on the detection signal SDET, and outputs a differential signal pair including signals SZ1O and SZ2O. The synchronous detection circuit 35A extracts physical quantity components included in the signals P1O and P2O output from the programmable gain amplifier 32. The synchronous detection circuit 35A may be, for example, a switch circuit that selects the signal P1O as the signal SZ1O and the signal P2O as the signal SZ2O when the voltage level of the detection signal SDET is higher than the reference voltage V_{ref}, and selects the signal P2O as the signal SZ1O and the signal P1O as the signal SZ2O when the voltage level of the detection signal SDET is lower than the reference voltage V_{ref}.

The smoothing circuit 36A smooths the signals SZ1O and SZ2O output from the synchronous detection circuit 35A into direct-current voltage signals and outputs a differential signal pair including the direct-current voltage signals. The signals output from the smoothing circuit 36A are output from the detection circuit 30 as physical quantity detection signals SA1O and SA2O.

The Q/V amplifiers 31A and 31B and the programmable gain amplifier 32 constitute an amplifier circuit 34 that amplifies a signal output from the physical quantity detection element 100. In other words, the amplifier circuit 34 includes the Q/V amplifiers 31A and 31B and the programmable gain amplifier 32 which are a plurality of amplifiers. The Q/V amplifier 31A is an example of a "first amplifier", the Q/V amplifier 31B is an example of a "second amplifier", and the programmable gain amplifier 32 is an example of a "third amplifier".

The amplifier circuit 34, the synchronous detection circuit 35A, and the smoothing circuit 36A constitute a physical quantity detection signal output circuit 37 that outputs the physical quantity detection signals SA1O and SA2O corresponding to the physical quantity detected by the physical quantity detection element 100. The physical quantity detection signal output circuit 37 amplifies a difference between the first signal and the second signal input from the detection electrodes 114 and 115 of the physical quantity detection element 100, respectively, by the Q/V amplifiers 31A and 31B and the programmable gain amplifier 32, performs synchronous detection on the signals P1O and P2O output from the programmable gain amplifier 32 based on the detection signal SDET, and outputs the physical quantity detection signals SA1O and SA2O based on the signals SZ1O and SZ2O obtained by the synchronous detection.

The adder circuit 33 outputs the signal FDO obtained by adding the signal S1O output from the Q/V amplifier 31A to the signal S2O output from the Q/V amplifier 31B. As described above, since the first physical quantity component included in the first signal and the second physical quantity component included in the second signal have the phases opposite to each other, the physical quantity components are attenuated by the adder circuit 33. On the other hand, since the phase of the first electrostatic leakage component included in the first signal and the phase of the second electrostatic leakage component included in the second signal are the same, the electrostatic leakage components are amplified by the adder circuit 33. Similarly, since the phase of the first vibration leakage component included in the first signal and the phase of the second vibration leakage component included in the second signal are the same, the vibration leakage components are amplified by the adder circuit 33.

The synchronous detection circuit 35B performs synchronous detection on the signal FDO output from the adder circuit 33. Specifically, the synchronous detection circuit 35B performs synchronous detection on the signal FDO output from the adder circuit 33 based on the detection signal QDET, and outputs a signal QZO. An electrostatic leakage component included in the signal FDO output from the adder circuit 33 is extracted by the synchronous detection circuit 35B. For example, the synchronous detection circuit 35B may be a switch circuit that selects, as the signal QZO, the signal FDO output from the adder circuit 33 when the voltage level of the detection signal QDET is higher than the reference voltage V_{ref}, and selects a signal obtained by inverting the signal FDO output from the adder circuit 33 with respect to the reference voltage V_{ref} when the voltage level of the detection signal QDET is lower than the reference voltage V_{ref}.

The smoothing circuit 36B smooths the signal QZO output from the synchronous detection circuit 35B into a direct-current voltage signal. The signal output from the smoothing circuit 36B is output from the detection circuit 30 as the electrostatic leakage detection signal QAO.

The synchronous detection circuit 35C performs synchronous detection on the signal FDO output from the adder circuit 33 based on the detection signal VDET, and outputs a signal VZO. The synchronous detection circuit 35B extracts a vibration leakage component included in the signal FDO output from the adder circuit 33. For example, the synchronous detection circuit 35C may be a switch circuit that selects, as the signal VZO, the signal FDO output from the adder circuit 33 when the voltage level of the detection signal VDET is higher than the reference voltage V_{ref}, and selects the signal obtained by inverting the signal FDO output from the adder circuit 33 with respect to the reference voltage V_{ref} when the voltage level of the detection signal VDET is lower than the reference voltage V_{ref}.

The smoothing circuit 36C smooths the signal VZO output from the synchronous detection circuit 35C into a direct-current voltage signal. The signal output from the smoothing circuit 36C is output from the detection circuit 30 as the vibration leakage detection signal VAO.

The adder circuit 33, the synchronous detection circuits 35B and 35C, and the smoothing circuits 36B and 36C constitute a failure diagnosis signal output circuit 38 that outputs the electrostatic leakage detection signal QAO and the vibration leakage detection signal VAO as failure diagnosis signals based on a signal output from at least one of the Q/V amplifiers 31A and 31B and the programmable gain amplifier 32 which are the plurality of amplifiers included in the amplifier circuit 34. The failure diagnosis signal output circuit 38 performs synchronous detection on the signal FDO obtained by adding the signal S1O output from the Q/V amplifier 31A to the signal S2O output from the Q/V amplifier 31B by the adder circuit 33 based on the detection signal QDET by the synchronous detection circuit 35B, and outputs the electrostatic leakage detection signal QAO, which is a failure diagnosis signal, based on the signal QZO obtained by the synchronous detection. Further, the failure diagnosis signal output circuit 38 performs synchronous detection on the signal FDO obtained by adding the signal S1O output from the Q/V amplifier 31A to the signal S2O output from the Q/V amplifier 31B by the adder circuit 33 based on the detection signal VDET by the synchronous detection circuit 35C and outputs the vibration leakage detection signal VAO, which is a failure diagnosis signal, based on the signal VZO obtained by the synchronous detection.

In addition, the selector 40, the analog-to-digital conversion circuit 42, and the failure diagnosis circuits 61 and 62 illustrated in FIG. 1 function as a failure diagnosis circuit that performs failure diagnosis based on the electrostatic leakage detection signal QAO and the vibration leakage detection signal VAO, which are failure diagnosis signals, and outputs the failure flags QF and VF indicating a result of the diagnosis.

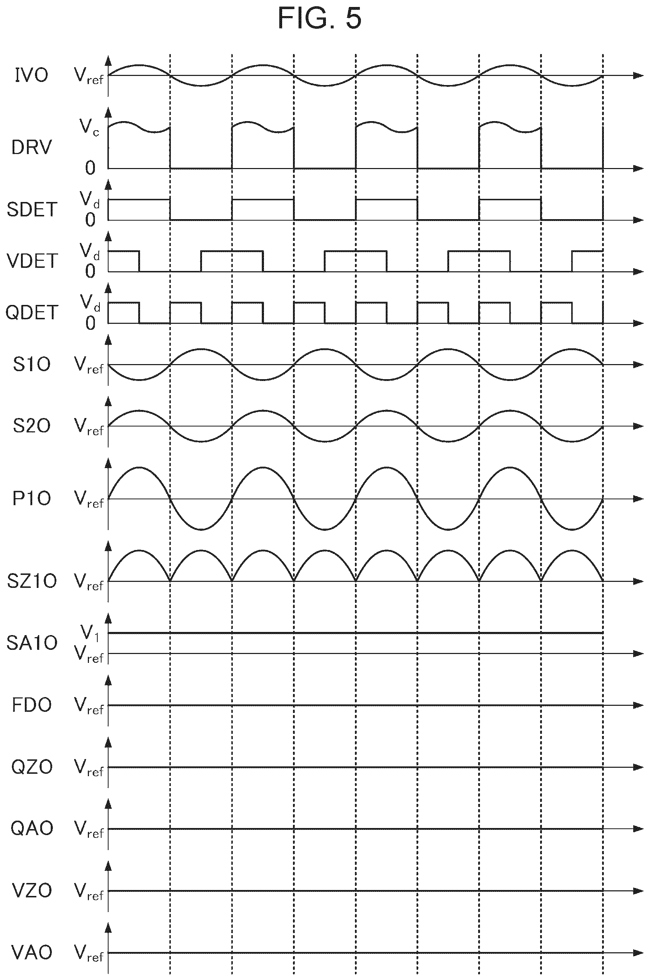

FIG. 5 is a diagram illustrating an example of waveforms of various signals with respect to physical quantity components included in alternating-current electrical charges output from the physical quantity detection element 100. In FIG. 5, for each of the waveforms of the signals, the horizontal axis represents time, and the vertical axis represents voltage. FIG. 5 illustrates an example of a case where a constant angular velocity is applied to the physical quantity detection element 100.

The signal IVO output from the current-to-voltage conversion circuit 21 is at the constant frequency f and has a voltage centered on the reference voltage V_{ref}.

The drive signal DRV is a square-wave voltage signal having the same phase as the signal IVO and having a fixed amplitude V_{c}. The drive signal DRV includes the first frequency component at the frequency f, and the second frequency component at the frequency 2f is superimposed on the high-level voltage of the drive signal DRV.

The detection signal SDET is a square-wave voltage signal having the same phase as the drive signal DRV and having a fixed amplitude V_{d}.

The detection signal VDET is a square-wave voltage signal that has a phase advanced by 90° from the phase of the drive signal DRV and has the fixed amplitude V_{d}. Therefore, the phase of the detection signal VDET is shifted by 90° from the phase of the detection signal SDET.

The detection signal QDET is a square-wave voltage signal at a frequency twice the frequency of the drive signal DRV and with the fixed amplitude V_{d}. Therefore, the frequency of the detection signal QDET is twice the frequency of the detection signal SDET.

The first physical quantity component included in the signal S1O output from the Q/V amplifier 31A is a signal at the constant frequency f and with a voltage centered on the reference voltage V_{ref}.

The second physical quantity component included in the signal S2O output from the Q/V amplifier 31B has a phase different from the phase of the signal S1O by 180° and is a signal at the constant frequency f and with a voltage centered on the reference voltage V_{ref}. The first physical quantity component included in the signal S1O and the second physical quantity component included in the signal S2O have the phases opposite to each other and substantially the same amplitudes.

A physical quantity component included in the signal P1O output from the programmable gain amplifier 32 is a signal obtained by amplifying a difference between the first physical quantity component included in the signal S1O and the second physical quantity component included in the signal S2O, has a phase opposite to the phase of the signal S1O, and is at the constant frequency f and has a voltage centered on the reference voltage V_{ref}. Although not illustrated, a physical quantity component included in the signal P2O output from the programmable gain amplifier 32 has a phase opposite to the phase of the physical quantity component included in the signal P1O and has the same amplitude as the physical quantity component included in the signal P1O.

A physical quantity component included in the signal SZ1O output from the synchronous detection circuit 35A is a signal obtained by performing full-wave rectification on the physical quantity component included in the signal P1O based on the detection signal SDET with reference to the reference voltage V_{ref}. Although not illustrated, a physical quantity component included in the signal SZ2O output from the synchronous detection circuit 35B is a signal obtained by performing full-wave rectification on the physical quantity component included in the signal P2O based on the detection signal SDET with reference to the reference voltage V_{ref}, and has a polarity opposite to that of the physical quantity component included in the signal SZ1O.

A physical quantity component included in the physical quantity detection signal SA1O is a signal of which a voltage value is V₁ corresponding to the physical quantity detected by the physical quantity detection element 100. Although not illustrated, a physical quantity component included in the physical quantity detection signal SA2O is a signal of which a voltage value is -V₁ corresponding to the physical quantity detected by the physical quantity detection element 100.

A physical quantity component included in the signal FDO output from the adder circuit 33 is a signal obtained by summing, amplifying, and substantially removing the first physical quantity component included in the signal S1O output from the Q/V amplifier 31A and the second physical quantity component included in the signal S2O output from the Q/V amplifier 31B, and the voltage value of this signal is equal to the reference voltage V_{ref}.

A physical quantity component included in the signal QZO output from the synchronous detection circuit 35B is a signal obtained by performing full-wave rectification on the physical quantity component included in the signal FDO output from the adder circuit 33 based on the detection signal QDET with reference to the reference voltage V_{ref}, and the voltage value of this signal is equal to the reference voltage V_{ref}. Therefore, a physical quantity component included in the electrostatic leakage detection signal QAO output from the smoothing circuit 36B is also a signal of which a voltage value is equal to the reference voltage V_{ref}.

A physical quantity component included in the signal VZO output from the synchronous detection circuit 35C is a signal obtained by performing full-wave rectification on the physical quantity component included in the signal FDO output from the adder circuit 33 based on the detection signal VDET with reference to the reference voltage V_{ref}, and the voltage value of this signal is equal to the reference voltage V_{ref}. Therefore, a physical quantity component included in the vibration leakage detection signal VAO output from the smoothing circuit 36C also is a signal of which a voltage value is equal to the reference voltage V_{ref}.

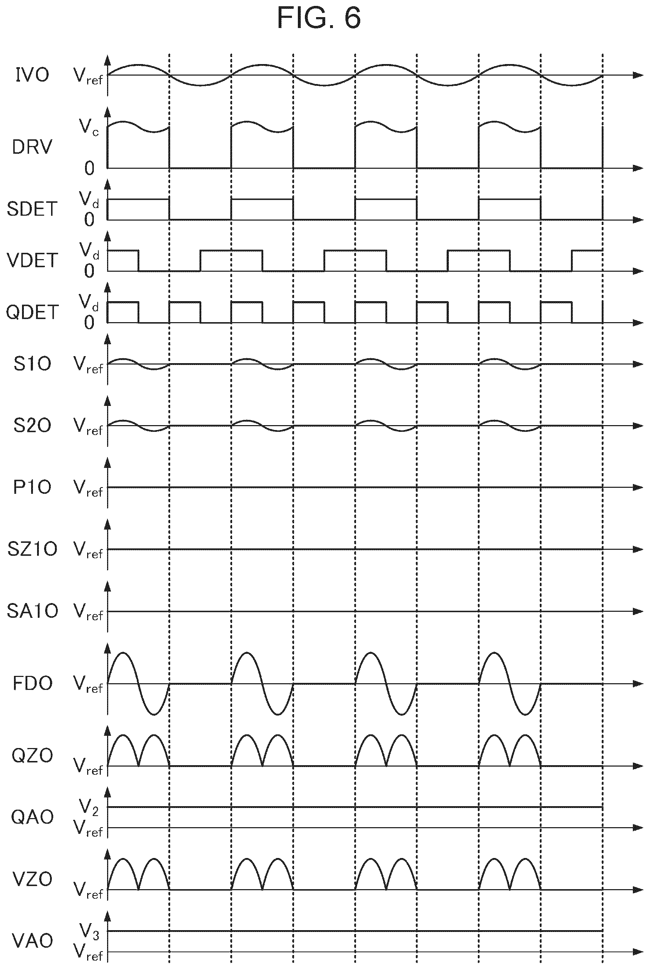

FIG. 6 is a diagram illustrating an example of waveforms of various signals with respect to electrostatic leakage components included in alternating-current electrical charges output from the physical quantity detection element 100. In FIG. 6, for each of the waveforms of the signals, the horizontal axis represents time, and the vertical axis represents voltage. In FIG. 6, the waveforms of the signals IVO, DRV, SDET, VDET, and QDET are the same as those illustrated in FIG. 5.

The first electrostatic leakage component included in the signal S1O output from the Q/V amplifier 31A is a signal at the constant-frequency 2f and with a voltage centered on the reference voltage V_{ref}. The first electrostatic leakage component is a component of the second frequency component of the frequency 2f superimposed on the high-level voltage of the drive signal DRV and propagated to the detection electrode 114 through the first electrostatic coupling capacitance C₁ present between the drive electrode 113 and the detection electrode 114. Therefore, the first electrostatic leakage component included in the signal S1O has the same phase as the second frequency component of the frequency 2f included in the drive signal DRV.

The second electrostatic leakage component included in the signal S2O output from the Q/V amplifier 31B is a signal at the constant frequency 2f and with a voltage centered on the reference voltage V_{ref}. The second electrostatic leakage component is a component of the second frequency component of the frequency 2f superimposed on the high-level voltage of the drive signal DRV and propagated to the detection electrode 115 through the second electrostatic coupling capacitance C₂ present between the drive electrode 113 and the detection electrode 115. Therefore, the second electrostatic leakage component included in the signal S2O has the same phase as the second frequency component of the frequency 2f included in the drive signal DRV. The first electrostatic leakage component included in the signal S1O and the second electrostatic leakage component included in the signal S2O have the same phase and have substantially the same amplitudes.

An electrostatic leakage component included in the signal P1O output from the programmable gain amplifier 32 is a signal obtained by amplifying and substantially removing a difference between the first electrostatic leakage component included in the signal S1O and the second electrostatic leakage component included in the signal S2O, and the voltage value of this signal is equal to the reference voltage V_{ref}. Although not illustrated, an electrostatic leakage component included in the signal P2O output from the programmable gain amplifier 32 is also a signal of which a voltage value is equal to the reference voltage V_{ref}.

An electrostatic leakage component included in the signal SZ1O output from the synchronous detection circuit 35A is a signal obtained by performing full-wave rectification on the electrostatic leakage component included in the signal P1O based on the detection signal SDET with reference to the reference voltage V_{ref}, and the voltage value of this signal is equal to the reference voltage V_{ref}. Although not illustrated, an electrostatic leakage component included in the signal SZ2O output from the synchronous detection circuit 35B is also a signal of which a voltage value is equal to the reference voltage V_{ref}.

An electrostatic leakage component included in the physical quantity detection signal SA1O is a signal of which a voltage value is equal to the reference voltage V_{ref}. Although not illustrated, an electrostatic leakage component included in the physical quantity detection signal SA2O is also a signal of which a voltage value is equal to the reference voltage V_{ref}.

The electrostatic leakage component included in the signal FDO output from the adder circuit 33 is a signal obtained by summing and amplifying the first electrostatic leakage component included in the signal S1O output from the Q/V amplifier 31A and the second electrostatic leakage component included in the signal S2O output from the Q/V amplifier 31B. Therefore, the electrostatic leakage component included in the signal FDO has the same phase as the second frequency component of the frequency 2f included in the drive signal DRV, and is a signal at the constant frequency 2f and with a voltage centered on the reference voltage V_{ref}.

An electrostatic leakage component included in the signal QZO output from the synchronous detection circuit 35B is a signal obtained by performing full-wave rectification on the electrostatic leakage component included in the signal FDO output from the adder circuit 33 based on the detection signal QDET with reference to the reference voltage V_{ref}. Therefore, an electrostatic leakage component included in the electrostatic leakage detection signal QAO output from the smoothing circuit 36B is a signal of which a voltage value is V₂ corresponding to electrostatic leakage that has occurred in the physical quantity detection element 100.

An electrostatic leakage component included in the signal VZO output from the synchronous detection circuit 35C is a signal obtained by performing full-wave rectification on the electrostatic leakage component included in the signal FDO output from the adder circuit 33 based on the detection signal VDET with reference to the reference voltage V_{ref}. Therefore, an electrostatic leakage component included in the vibration leakage detection signal VAO output from the smoothing circuit 36C is a signal of which a voltage value is V₃ corresponding to the electrostatic leakage that has occurred in the physical quantity detection element 100.

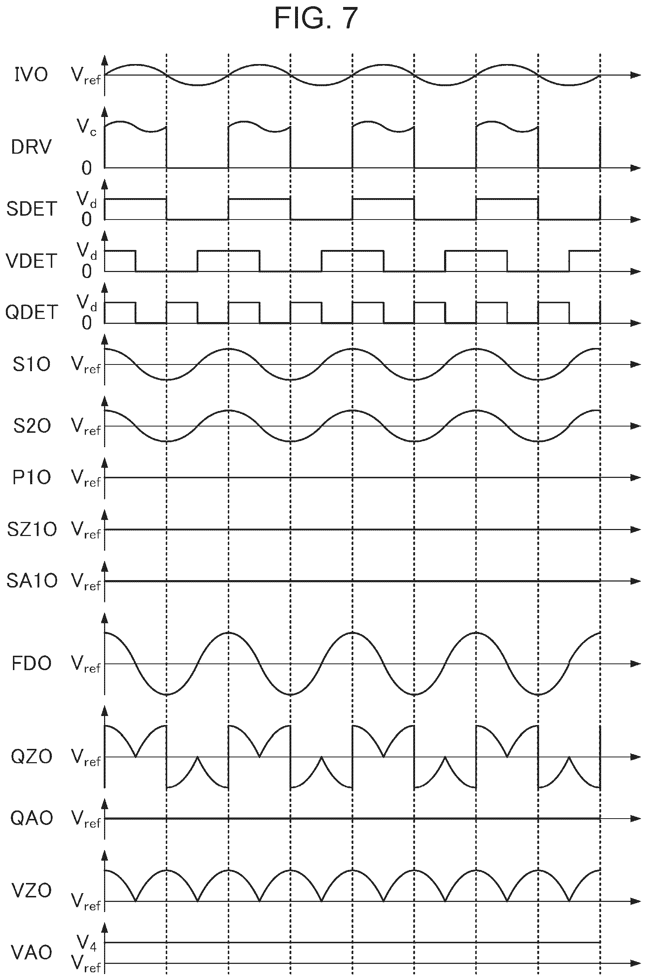

FIG. 7 is a diagram illustrating an example of waveforms of various signals with respect to vibration leakage components included in alternating-current electrical charges output from the physical quantity detection element 100 if the physical quantity detection element 100 fails. In FIG. 7, for each of the waveforms of the signals, the horizontal axis represents time, and the vertical axis represents voltage. In FIG. 7, the waveforms of the signals IVO, DRV, SDET, VDET, and QDET are the same as those illustrated in FIGS. 5 and 6.

The first vibration leakage component included in the signal S1O output from the Q/V amplifier 31A has a phase advanced by 90° from the phase of the signal IVO and is a signal at the constant frequency f and with a voltage centered on the reference voltage V_{ref}.

The second vibration leakage component included in the signal S2O output from the Q/V amplifier 31A has a phase advanced by 90° from the phase of the signal IVO and is a signal at the constant frequency f and with a voltage centered on the reference voltage V_{ref}.

The first vibration leakage component included in the signal S1O and the second vibration leakage component included in the signal S2O have the same phase and have substantially the same amplitudes.

A vibration leakage component included in the signal P1O output from the programmable gain amplifier 32 is a signal obtained by amplifying and substantially removing the difference between the first vibration leakage component included in the signal S1O and the second vibration leakage component included in the signal S2O, and the voltage value of this signal is equal to the reference voltage V_{ref}. Although not illustrated, a vibration leakage component included in the signal P2O output from the programmable gain amplifier 32 is also a signal of which a voltage value is equal to the reference voltage V_{ref}.

A vibration leakage component included in the signal SZ1O output from the synchronous detection circuit 35A is a signal obtained by performing full-wave rectification on the vibration leakage component included in the signal P1O based on the detection signal SDET with reference to the reference voltage V_{ref}, and the voltage value of this signal is equal to the reference voltage V_{ref}. Although not illustrated, a vibration leakage component included in the signal SZ2O output from the synchronous detection circuit 35B is also a signal of which a voltage value is equal to the reference voltage V_{ref}.

A vibration leakage component included in the physical quantity detection signal SA1O is a signal of which a voltage value is equal to the reference voltage V_{ref}. Although not illustrated, a vibration leakage component included in the physical quantity detection signal SA2O is also a signal of which a voltage value is equal to the reference voltage V_{ref}.

A vibration leakage component included in the signal FDO output from the adder circuit 33 is a signal obtained by summing and amplifying the first vibration leakage component included in the signal S1O output from the Q/V amplifier 31A and the second vibration leakage component included in the signal S2O output from the Q/V amplifier 31B. Therefore, the vibration leakage component included in the signal FDO has a phase advanced by 90° from the phase of the signal IVO, and is a signal at the constant frequency f and with a voltage centered on the reference voltage V_{ref}.

A vibration leakage component included in the signal QZO output from the synchronous detection circuit 35B is a signal obtained by performing full-wave rectification on the vibration leakage component included in the signal FDO output from the adder circuit 33 based on the detection signal QDET with reference to the reference voltage V_{ref}, and has a polarity inverted with reference to the reference voltage V_{ref} in each period of the detection signal QDET. Therefore, a vibration leakage component included in the electrostatic leakage detection signal QAO output from the smoothing circuit 36B is a signal of which a voltage value is equal to the reference voltage V_{ref}.

A vibration leakage component included in the signal VZO output from the synchronous detection circuit 35C is a signal obtained by performing full-wave rectification on the vibration leakage component included in the signal FDO output from the adder circuit 33 based on the detection signal VDET with reference to the reference voltage V_{ref}. Therefore, a vibration leakage component included in the vibration leakage detection signal VAO output from the smoothing circuit 36C is a signal of which a voltage value is V₄ corresponding to vibration leakage that has occurred in the physical quantity detection element 100.

Actually, each of the signals has a waveform obtained by summing a corresponding waveform among the waveforms illustrated in FIG. 5, a corresponding waveform among the waveform illustrated in FIG. 6, and a corresponding waveform among the waveform illustrated in FIG. 7. As illustrated in FIGS. 6 and 7, the physical quantity detection signals SA1O and SA2O hardly include an electrostatic leakage component and a vibration leakage component, and as illustrated in FIG. 5, the physical quantity detection signals SA1O and SA2O are at the voltage levels corresponding to the physical quantity components. In this way, since an electrostatic leakage component and a vibration leakage component are hardly included in each of the physical quantity detection signals SA1O and SA2O, the adverse effect of the electrostatic leakage component and the vibration leakage component on the detection of the physical quantity is extremely minor. Therefore, the MCU 5 can measure the physical quantity applied to the physical quantity detection device 1 by reading the physical quantity detection signal SDO generated based on the physical quantity detection signals SA1O and SA2O.

Further, as illustrated in FIGS. 5 and 7, the electrostatic leakage detection signal QAO hardly includes a physical quantity component and a vibration leakage component, and as illustrated in FIG. 6, the electrostatic leakage detection signal QAO is at the voltage level corresponding to the electrostatic leakage component. As described above, since the electrostatic leakage detection signal QAO hardly includes the physical quantity component and the vibration leakage component, the adverse effect of the physical quantity component and the vibration leakage component on the failure diagnosis based on the electrostatic leakage component is extremely minor. When the wiring of the physical quantity detection element 100 is normal, the voltage of the electrostatic leakage detection signal QAO has a predetermined value. Therefore, when the value of the electrostatic leakage detection signal QDO generated based on the electrostatic leakage detection signal QAO is not in the predetermined first range, the failure diagnosis circuit 61 can diagnose that the wiring of the physical quantity detection element 100 has failed.

The vibration leakage detection signal VAO hardly includes a physical quantity component as illustrated in FIG. 5, but includes the electrostatic leakage component as illustrated in FIG. 6. Therefore, the vibration leakage detection signal VAO is at a voltage level corresponding to the vibration leakage component with reference to the voltage value V₃ corresponding to the electrostatic leakage component. As described above, since the vibration leakage detection signal VAO hardly includes a physical quantity component, the adverse effect of the physical quantity component on the failure diagnosis based on the vibration leakage component is extremely minor. When the vibration leakage detection signal VAO includes the electrostatic leakage component but the wiring of the physical quantity detection element 100 is normal, the magnitude of the electrostatic leakage component is constant, and when the physical quantity detection element 100 is normal, the vibration leakage component is substantially zero. Therefore, the vibration leakage detection signal VAO is at a voltage level close to the voltage value V₃. Therefore, when the value of the vibration leakage detection signal VDO generated based on the vibration leakage detection signal VAO is not in the predetermined second range, the failure diagnosis circuit 62 can diagnose that the physical quantity detection element 100 has failed.

### 4. Configuration and Operation of Mask Signal Output Circuit

As described above, when both of the wiring coupling the detection electrode 114 of the physical quantity detection element 100 to the S1 terminal of the semiconductor device 200 and the wiring coupling the detection electrode 115 of the physical quantity detection element 100 to the S2 terminal of the semiconductor device 200 are normal, the failure diagnosis circuit 61 determines that the value of the electrostatic leakage detection signal QDO is in the predetermined first range. If at least one of the wiring coupling the detection electrode 114 of the physical quantity detection element 100 to the S1 terminal of the semiconductor device 200 and the wiring coupling the detection electrode 115 of the physical quantity detection element 100 to the S2 terminal of the semiconductor device 200 is abnormal, the failure diagnosis circuit 61 determines that the value of the electrostatic leakage detection signal QDO is out of the predetermined first range. The failure diagnosis circuit 61 outputs the failure flag QF indicating whether the physical quantity detection device 1 has failed. When the physical quantity detection element 100 is normal, the failure diagnosis circuit 62 determines that the value of the vibration leakage detection signal VDO is in the predetermined second range. If the physical quantity detection element 100 fails, the failure diagnosis circuit 62 determines that the value of the vibration leakage detection signal VDO is out of the predetermined second range. The failure diagnosis circuit 62 outputs the failure flag VF indicating whether or not the physical quantity detection device 1 has failed.

However, when an abnormal signal other than the electrostatic leakage components and the vibration leakage components is temporarily input to the S1 terminal or the S2 terminal, the value of the electrostatic leakage detection signal QDO may deviate from the predetermined first range and the failure flag QF may temporarily become a high level, or the value of the vibration leakage detection signal VDO may deviate from the predetermined second range and the failure flag VF may temporarily become a high level. In such a case, since the physical quantity detection device 1 does not fail, it is preferable to mask and disable the failure flags QF and VF. When an abnormal signal is input to the terminal S1 and the terminal S2, the abnormal signal propagates to the outputs of the Q/V amplifiers 31A and 31B and the programmable gain amplifier 32, which are the plurality of amplifiers, and the output of the adder circuit 33. Therefore, in the present embodiment, the mask signal output circuit 70 compares a signal output from each of the plurality of amplifiers with each of a plurality of set detection levels and outputs the mask signal MSK based on a result of the comparison, and the disabling determination circuit 80 disables the failure flags QF and VF based on the mask signal MSK. Although the programmable gain amplifier 32 outputs the two signals P1O and P2O having the phases opposite to each other, since these two signals P1O and P2O have substantially the same amplitudes, the mask signal output circuit 70 may compare only one of the signals P1O and P2O with a detection level.

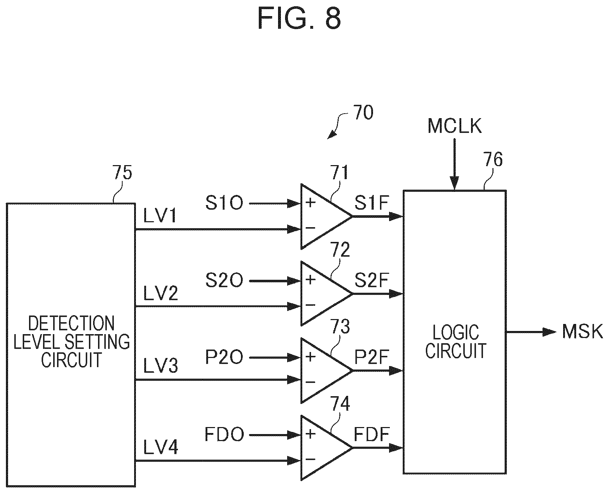

FIG. 8 is a diagram illustrating an example of a configuration of the mask signal output circuit 70. As illustrated in FIG. 8, the mask signal output circuit 70 includes comparators 71, 72, 73, and 74, a detection level setting circuit 75, and a logic circuit 76.

The comparator 71 compares the level of the signal S1O output from the Q/V amplifier 31A with a set detection level LV1, and outputs a comparison result signal S1F indicating a result of the comparison. Specifically, the comparator 71 outputs the comparison result signal S1F at a low level when the voltage level of the signal S1O is lower than the detection level LV1, and outputs the comparison result signal S1F at a high level when the voltage level of the signal S1O is higher than the detection level LV1.

The comparator 72 compares the level of the signal S2O output from the Q/V amplifier 31B with a set detection level LV2, and outputs a comparison result signal S2F indicating a result of the comparison. Specifically, the comparator 72 outputs the comparison result signal S2F at a low level when the voltage level of the signal S2O is lower than the detection level LV2, and outputs the comparison result signal S2F at a high level when the voltage level of the signal S2O is higher than the detection level LV2.

The comparator 73 compares the level of the signal P2O output from the programmable gain amplifier 32 with a set detection level LV3, and outputs a comparison result signal P2F indicating a result of the comparison. Specifically, the comparator 73 outputs the comparison result signal P2F at a low level when the voltage level of the signal P2O is lower than the detection level LV3, and outputs the comparison result signal P2F at a high level when the voltage level of the signal P2O is higher than the detection level LV3. The comparator 73 may compare the level of the signal P1O output from the programmable gain amplifier 32 with the detection level LV3, and may output the comparison result signal P2F.

The comparator 74 compares the level of the signal FDO output from the adder circuit 33 with a set detection level LV4, and outputs a comparison result signal FDF indicating a result of the comparison. Specifically, the comparator 74 outputs the comparison result signal FDF at a low level when the voltage level of the signal FDO is lower than the detection level LV4, and outputs the comparison result signal FDF at a high level when the voltage level of the signal FDO is higher than the detection level LV4.

The comparator 71 is an example of a "first comparator", the comparator 72 is an example of a "second comparator", the comparator 73 is an example of a "third comparator", and the comparator 74 is an example of a "fourth comparator". Further, the detection level LV1 is an example of a "first detection level", the detection level LV2 is an example of a "second detection level", the detection level LV3 is an example of a "third detection level", and the detection level LV4 is an example of a "fourth detection level". The comparison result signal S1F is an example of a "first comparison result signal", the comparison result signal S2F is an example of a "second comparison result signal", the comparison result signal P2F is an example of a "third comparison result signal", and the comparison result signal FDF is an example of a "fourth comparison result signal".

The detection level setting circuit 75 outputs the detection levels LV1, LV2, LV3, and LV4. For example, the detection levels LV1, LV2, LV3, and LV4 are set to levels corresponding to thresholds for determining whether or not an assumed abnormal signal has been input. The detection levels LV1, LV2, LV3, and LV4 may be fixed or may be variable. For example, the detection levels LV1, LV2, LV3, and LV4 may be variably set in accordance with a value stored in a register included in the storage section 91 and rewritable from the outside of the semiconductor device 200.

The logic circuit 76 operates based on the master clock signal MCLK, and outputs the mask signal MSK based on the comparison result signals S1F, S2F, P2F, and FDF. The correspondence between the logic levels of the comparison result signals S1F, S2F, P2F, and FDF and the logic levels of the mask signal MSK is determined such that the mask signal MSK becomes a low level if the physical quantity detection device 1 fails, and the mask signal MSK becomes a high level when each of a plurality of kinds of assumed abnormal signals is input.

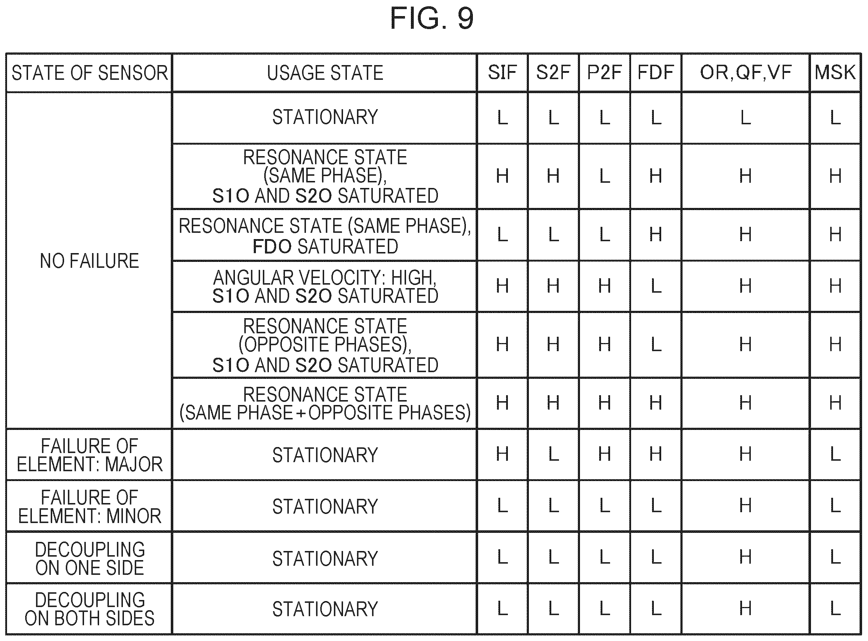

FIG. 9 is a diagram illustrating an example of the correspondence between the logic levels of the comparison result signals S1F, S2F, P2F, and FDF and the logic levels of the mask signal MSK. In FIG. 9, "L" represents a low level, and "H" represents a high level.

For example, when the physical quantity detection element 100 resonates due to environmental vibration, resonance signals having the same phase or opposite phases are input to the S1 terminal and the S2 terminal as abnormal signals. Alternatively, when an excessive angular velocity exceeding a detectable range is temporarily applied to the physical quantity detection element 100, excessive angular velocity components having opposite phases are input to the S1 terminal and the S2 terminal as abnormal signals.

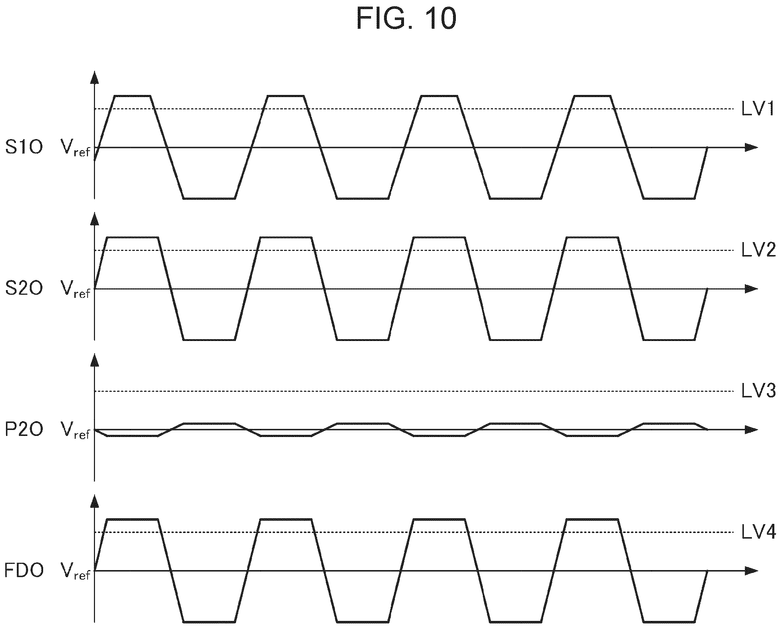

When the resonance signals having the same phase and large amplitudes are input, as illustrated in FIG. 10, the signals S1O and S2O output from the Q/V amplifiers 31A and 31B are saturated and become rectangular waves, and at least one of the failure flags QF and VF becomes a high level. In this case, the comparison result signals S1F, S2F, and FDF become a high level, and the comparison result signal P2F becomes a low level. Therefore, when the comparison result signal S1F is at a high level, the comparison result signal S2F is at a high level, the comparison result signal P2F is at a low level, and the comparison result signal FDF is at a high level, the logic circuit 76 outputs the mask signal MSK at a high level indicating that the failure flags QF and VF are to be disabled. Therefore, both of the failure diagnosis result signals QFX and VFX become a low level.

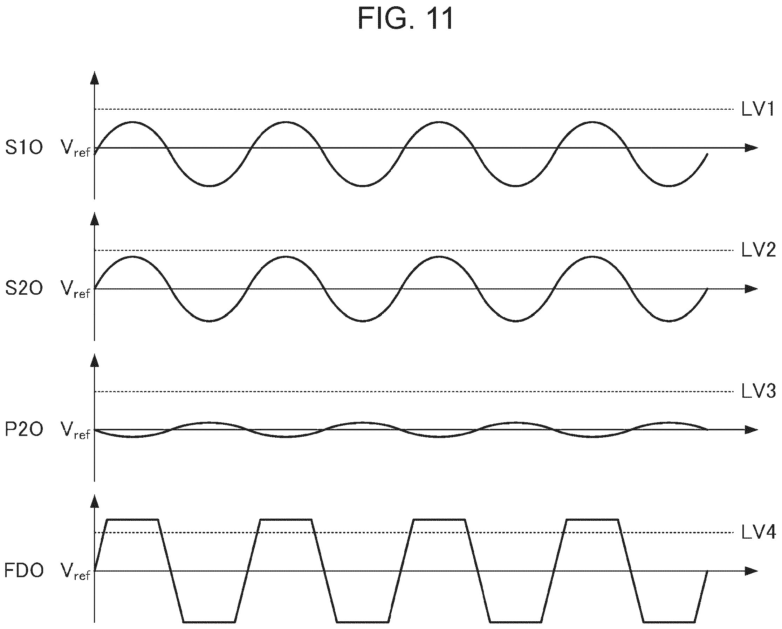

On the other hand, when resonance signals having the same phase and relatively small amplitudes are input, as illustrated in FIG. 11, the signals S1O and S2O output from the Q/V amplifiers 31A and 31B are not saturated, the signal FDO output from the adder circuit 33 is saturated and becomes a rectangular wave, and at least one of the failure flags QF and VF becomes a high level. In this case, the comparison result signals S1F, S2F, and P2F become a low level, and the comparison result signal FDF becomes a high level. Therefore, when the comparison result signal S1F is at a low level, the comparison result signal S2F is at a low level, the comparison result signal P2F is at a low level, and the comparison result signal FDF is at a high level, the logic circuit 76 outputs the mask signal MSK at a high level indicating that the failure flags QF and VF are to be disabled. Therefore, both of the failure diagnosis result signals QFX and VFX become a low level.

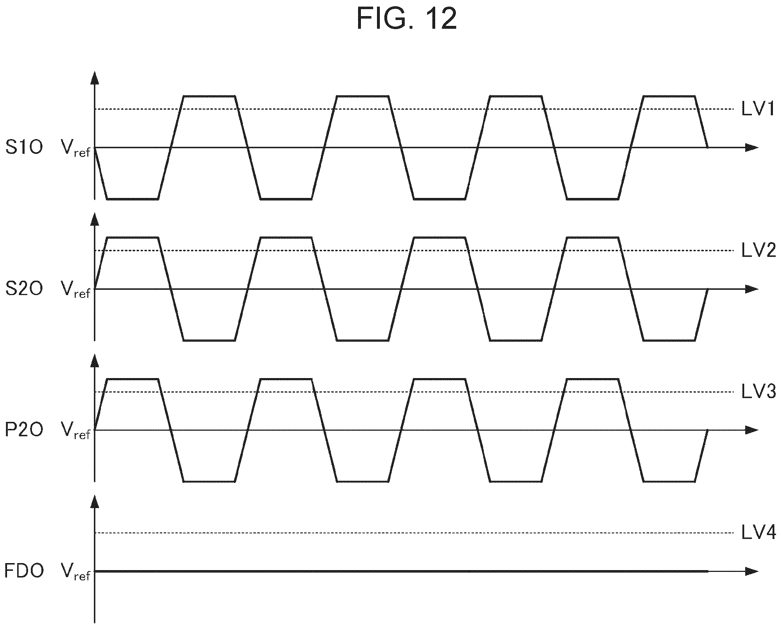

Further, when excessive angular velocity components are input or when resonance signals having opposite phases and large amplitudes are input, as illustrated in FIG. 12, the signals S1O and S2O output from the Q/V amplifiers 31A and 31B are saturated and become rectangular waves, and at least one of the failure flags QF and VF becomes a high level. In this case, the comparison result signals S1F, S2F, and P2F become a high level, and the comparison result signal FDF becomes a low level. Further, when resonance signals having the same phase and resonance signals having opposite phases are input, the signals S1O and S2O output from the Q/V amplifiers 31A and 31B are saturated and become rectangular waves, and at least one of the failure flags QF and VF becomes a high level. In this case, all of the comparison result signals S1F, S2F, P2F, and FDF become a high level. Therefore, when the comparison result signal S1F is at a high level, the comparison result signal S2F is at a high level, and the comparison result signal P2F is at a high level, the logic circuit 76 outputs the mask signal MSK at a high level indicating that the failure flags QF and VF are to be disabled, regardless of the logic level of the comparison result signal FDF. Therefore, both of the failure diagnosis result signals QFX and VFX become a low level.

On the other hand, when the physical quantity detection element 100 is normal, both of the failure flags QF and VF are at a low level. In this case, all of the comparison result signals S1F, S2F, P2F, and FDF are at a low level. Further, if the physical quantity detection element 100 has a minor failure, or if one or both of the wiring coupling the detection electrode 114 to the S1 terminal and the wiring coupling the detection electrode 115 to the S2 terminal are decoupled, at least one of the failure flags QF and VF becomes a high level, and also in this case, all of the comparison result signals S1F, S2F, P2F, and FDF become a low level. Therefore, when all of the comparison result signals S1F, S2F, P2F, and FDF are at a low level, the logic circuit 76 outputs the mask signal MSK at a low level indicating that the failure flags QF and VF are not to be disabled. Therefore, the failure diagnosis result signals QFX and VFX become the same logic levels as the failure flags QF and VF, respectively.

In addition, if the physical quantity detection element 100 has a major failure, since large leakage vibration occurs, the signal S1O output from the Q/V amplifier 31A is saturated and becomes a rectangular wave, and at least one of the failure flags QF and VF becomes a high level. In this case, the comparison result signals S1F, P2F, and FDF become a high level, and the comparison result signal S2F becomes a low level. Therefore, when the comparison result signals S1F, P2F, and FDF are at a high level and the comparison result signal S2F is at a low level, the logic circuit 76 outputs the mask signal MSK at a low level indicating that the failure flags QF and VF are not to be disabled. Therefore, the failure diagnosis result signals QFX and VFX have the same logic levels as the failure flags QF and VF, respectively.

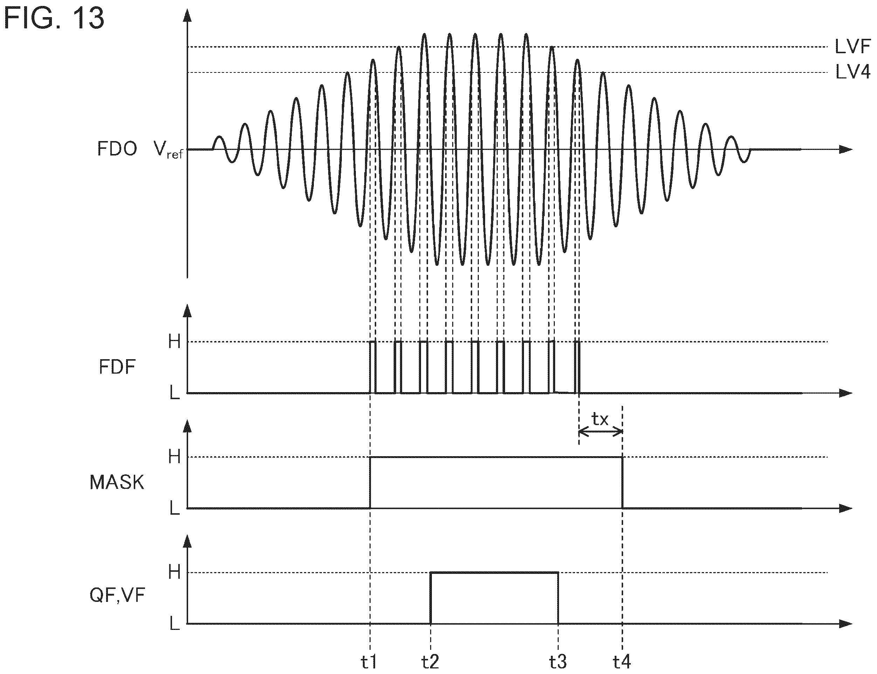

In order to prevent the failure diagnosis result signals QFX and VFX from erroneously becoming a high level when an abnormal signal such as a resonance signal is input, periods of time when the failure flags QF and VF are at a high level need to be included in a period of time when the mask signal MSK is at a high level. For example, when an impact is applied to the physical quantity detection element 100 and in-phase resonance is excited, as illustrated in FIG. 13, the amplitude of the signal FDO output from the adder circuit 33 gradually increases. The comparison result signal FDF is at a low level when the voltage level of the signal FDO is lower than the detection level LV4, and is at a high level when the voltage level of the signal FDO is higher than the detection level LV4. That is, after the comparison result signal FDF changes from a low level to a high level, the logic level of the comparison result signal FDF periodically alternates between high and low levels until the resonance becomes small.

When the mask signal MSK is at a low level and the comparison result signal FDF changes from a low level to a high level, the logic circuit 76 changes the mask signal MSK from a low level to a high level. Further, after changing the mask signal MSK to a high level, the logic circuit 76 changes the mask signal MSK from a high level to a low level when a time period tx elapses while the comparison result signal FDF is maintained at a low level after changing from a high level to a low level. For example, the logic circuit 76 changes the mask signal MSK from a high level to a low level when the comparison result signal FDF is maintained at a low level from the time when the comparison result signal FDF changes from a high level to a low level until the number of pulses of the master clock signal MCLK corresponding to the time period tx is counted. The time period tx is set to be longer than a resonance period of the physical quantity detection element 100.

On the other hand, when the amplitude of the signal FDO gradually increases and the voltage level of the signal FDO exceeds the detection level LV4 and reaches a level close to a voltage level LVF, the failure flag QF changes from a low level to a high level. When the amplitude of the signal FDO gradually decreases and the voltage level of the signal FDO becomes lower than the voltage level LVF, the failure flag QF changes from a high level to a low level. In other words, the detection level LV4 is set to a voltage lower than the voltage level LVF at which it is determined that the physical quantity detection device 1 has failed in terms of the signal FDO. Since the detection level LV4 is set to a voltage lower than the voltage level LVF, a rising edge of the mask signal MSK at time t1 is earlier than a rising edge of the failure flag QF at time t2, and a falling edge of the mask signal MSK at time t4 is later than a falling edge of the failure flag QF at time t3. Therefore, a period of time when the failure flag QF is at a high level is included in a period of time when the mask signal MSK is at a high level, and it is possible to prevent the failure diagnosis result signal QFX from erroneously becoming a high level. The detection levels LV1, LV2, and LV3 are also set to voltage levels that cause a rising edge of the mask signal MSK to be earlier than a rising edge of the failure flag QF and cause a falling edge of the mask signal MSK to be later than a falling edge of the failure flag QF. Similarly to the failure flag QF, regarding the failure flag VF, the detection levels LV1, LV2, LV3, and LV4 are set such that a rising edge of the mask signal MSK is earlier than a rising edge of the failure flag VF and a falling edge of the falls mask signal MSK is later than a falling edge of the failure flag VF.

### 5. Effects

In the physical quantity detection device 1 according to the present embodiment, if a failure such as decoupling occurs in the wiring coupling the physical quantity detection element 100 and the physical quantity detection circuit 210, the magnitudes of the first and second electrostatic leakage components which are components of the second frequency component included in the drive signal DRV and have been propagated to the detection electrodes 114 and 115, respectively, change. Therefore, the electrostatic leakage detection signal QAO generated by the failure diagnosis signal output circuit 38 based on the first electrostatic leakage component and the second electrostatic leakage component also changes, and the failure diagnosis circuit 61 can diagnose the failure of the wiring based on the electrostatic leakage detection signal QDO obtained by converting the electrostatic leakage detection signal QAO.

Further, in the physical quantity detection device 1 according to the present embodiment, if a failure such as breakage occurs in the physical quantity detection element 100, the magnitudes of the first and second vibration leakage components generated in the detection electrodes 114 and 115, respectively, based on the vibration of the physical quantity detection element 100 change. Therefore, the vibration leakage detection signal VAO generated by the failure diagnosis signal output circuit 38 based on the first vibration leakage component and the second vibration leakage component also changes, and the failure diagnosis circuit 62 can diagnose the failure of the physical quantity detection element 100 based on the vibration leakage detection signal VDO obtained by converting the vibration leakage detection signal VAO.

Further, in the physical quantity detection device 1 according to the present embodiment, since the physical quantity component included in the first signal output from the detection electrode 114 and the physical quantity component included in the second signal output from the detection electrode 115 have the opposite phases, the physical quantity components are amplified by the programmable gain amplifier 32 and attenuated by the adder circuit 33 in the physical quantity detection circuit 210. Therefore, the physical quantity detection circuit 210 can accurately generate the physical quantity detection signal SDO, and it is possible to reduce the possibility that the accuracy of the electrostatic leakage detection signal QDO and the vibration leakage detection signal VDO may decrease due to the physical quantity components.

In the physical quantity detection device 1 according to the present embodiment, the phase of the first electrostatic leakage component included in the first signal and the phase of the second electrostatic leakage component included in the second signal are the same, and the phase of the first vibration leakage component included in the first signal and the phase of the second vibration leakage component included in the second signal are the same. Therefore, in the physical quantity detection circuit 210, the electrostatic leakage components and the vibration leakage components are amplified by the adder circuit 33 and attenuated by the programmable gain amplifier 32. Therefore, the physical quantity detection circuit 210 can accurately generate the electrostatic leakage detection signal QDO and the vibration leakage detection signal VDO, and the possibility that the accuracy of the physical quantity detection signal SDO may decrease due to the electrostatic leakage components and the vibration leakage components is reduced.

Further, in the physical quantity detection device 1 according to the present embodiment, since the failure diagnosis circuit 61 can perform the failure diagnosis on the wiring coupling the physical quantity detection element 100 and the physical quantity detection circuit 210 based on the electrostatic leakage components, the physical quantity detection element 100 which has been tuned such that the magnitudes of the vibration leakage components are zero or close to zero can be used. Therefore, according to the physical quantity detection device 1 according to the present embodiment, it is possible to reduce the possibility that the accuracy of detecting the physical quantity may decrease due to the vibration leakage components.

Further, in the physical quantity detection device 1 according to the present embodiment, if the physical quantity detection element 100 is temporarily brought into an abnormal state due to application of mechanical impact or vibration and an abnormal signal is input to the physical quantity detection circuit 210, there is a possibility that the failure flags QF and VF indicating a failure of the physical quantity detection device 1 may be output. In this case, the failure flags QF and VF are disabled based on the mask signal MSK. In particular, by setting a rising edge of the mask signal MSK to be earlier than rising edges of the failure flags QF and VF and setting a falling edge of the mask signal MSK to be later than falling edges of the failure flags QF and VF, an entire period of time when the failure flags QF and VF at a high level are output is included in a period of time when the mask signal MSK at a high level is output. Therefore, the failure flags QF and VF can be reliably disabled. Therefore, according to the physical quantity detection device 1 according to the present embodiment, when an abnormal signal generated due to resonance or the like of the physical quantity detection element 100 is input to the physical quantity detection circuit 210, it is possible to reduce the possibility that the physical quantity detection device 1 may be erroneously diagnosed as failing.

### 6. Modifications

The present disclosure is not limited to the present embodiment, and various modifications can be made within the scope of the gist of the present disclosure.

For example, in the above-described embodiment, the mask signal output circuit 70 compares the voltage levels of the signals S1O, S2O, P2O, and FDO with the positive detection levels LV1, LV2, LV3, and LV4, respectively, and outputs the comparison result signals S1F, S2F, P2F, and FDF, but may compare the voltage levels of the signals S1O, S2O, P2O, and FDO with negative detection levels LV1', LV2', LV3', and LV4' and output the comparison result signals S1F, S2F, P2F, and FDF. Alternatively, the mask signal output circuit 70 may compare the voltage levels of the signals S1O, S2O, P2O, and FDO with the positive detection levels LV1, LV2, LV3, and LV4 and the negative detection levels LV1', LV2', LV3', and LV4', respectively, and output the comparison result signals S1F, S2F, P2F, and FDF.

In the above-described embodiment, the physical quantity detection device 1 generates the failure diagnosis result signals QFX and VFX based on the failure flags QF and VF and outputs the failure diagnosis result signals QFX and VFX to the outside through the interface circuit 90, but may generate a single failure diagnosis result signal QVFX based on a failure flag QVF which is a logical sum of the failure flag QF and the failure flag VF, and output the failure diagnosis result signal QVFX to the outside through the interface circuit 90.

In the embodiment described above, the physical quantity detection device 1 includes the physical quantity detection element 100 that detects the angular velocity as the physical quantity, but may include a physical quantity detection element that detects a physical quantity other than an angular velocity. For example, the physical quantity detection device 1 may include a physical quantity detection element that detects a physical quantity such as an acceleration, an angular acceleration, a velocity, or a force.

In the above-described embodiment, the physical quantity detection device 1 includes the single physical quantity detection element, but may include a plurality of physical quantity detection elements. For example, the physical quantity detection device 1 may include a plurality of physical quantity detection elements, and each of the plurality of physical quantity detection elements may detect a physical quantity using any one of two or more axes orthogonal to each other as a detection axis. Further, for example, the physical quantity detection device 1 may include a plurality of physical quantity detection elements, and each of the plurality of physical quantity detection elements may detect any one of a plurality of types of physical quantities such as an angular velocity, an acceleration, an angular acceleration, a velocity, and a force. That is, the physical quantity detection device 1 may be a composite sensor.

In addition, in the above-described embodiment, the example in which the vibrator element of the physical quantity detection element 100 is a double-T type quartz crystal vibrator element has been described, but the vibrator element of the physical quantity detection element which detects various physical quantities may be of, for example, a tuning fork type or a comb tooth type, or may be of a vibrating reed type having a shape such as a triangular prism, a quadrangular prism, or a cylindrical shape. As the material of the vibrator element of the physical quantity detection element, instead of quartz crystal (SiO₂), for example, a piezoelectric material such as piezoelectric single crystal such as lithium tantalate (LiTaO₃) or lithium niobate (LiNbO₃) or piezoelectric ceramic such as lead zirconate titanate (PZT) may be used, or a silicon semiconductor may be used. For example, the vibrator element of the physical quantity detection element may have a structure in which a piezoelectric thin film made of zinc oxide (ZnO), aluminum nitride (AIN), or the like and interposed between drive electrodes is disposed on a portion of a surface of a silicon semiconductor. For example, the physical quantity detection element may be a MEMS element. MEMS is an abbreviation for Micro Electro Mechanical Systems.

In addition, in the embodiment described above, the piezoelectric physical quantity detection element is exemplified, but the physical quantity detection element which detects various physical quantities is not limited to the piezoelectric element, and the physical quantity detection element may be an electrostatic capacitance type element, an electrodynamic type element, an eddy current type element, an optical type element, a strain gauge type element, or the like. The detection method of the physical quantity detection element is not limited to the vibration method, and may be, for example, an optical method, a rotation method, or a fluid method.

The above-described embodiments and modifications are merely examples, and the present disclosure is not limited thereto. For example, each of the embodiments and each of the modifications may be combined as appropriate.

The present disclosure includes configurations that are substantially the same as the configurations described in the embodiments. For example, the present disclosure includes a configuration having the same functions, methods, and results as those described in the embodiments, or a configuration having the same purposes and effects as those described in the embodiments. Further, the present disclosure includes configurations in which non-essential portions of the configuration described in the embodiments are replaced. In addition, the present disclosure includes configurations that achieve the same effects as the configurations described in the embodiments or includes configurations that can achieve the same purposes as the configurations described in the embodiments. Further, the present disclosure includes configurations in which a known technology is added to the configurations described in the embodiments.

The following contents are derived from the above-described embodiments and modifications.

In one aspect, a physical quantity detection circuit includes a physical quantity detection signal output circuit that includes an amplifier circuit that amplifies a signal output from a physical quantity detection element that detects a physical quantity, and outputs a physical quantity detection signal corresponding to the physical quantity, a failure diagnosis signal output circuit that outputs a failure diagnosis signal based on a signal output from at least one of a plurality of amplifiers included in the amplifier circuit, a failure diagnosis circuit that performs failure diagnosis based on the failure diagnosis signal and outputs a failure flag indicating a result of the failure diagnosis, a mask signal output circuit that compares a level of a signal output from each of the plurality of amplifiers with each of a plurality of set detection levels and outputs a mask signal based on a result of the comparison, and a disabling determination circuit that disables the failure flag based on the mask signal.

In this physical quantity detection circuit, if a failure such as decoupling occurs in wiring coupled to the physical quantity detection element, signals output from the plurality of amplifiers change, and thus the failure diagnosis signal changes. Therefore, the failure diagnosis circuit can perform the failure diagnosis based on the failure diagnosis signal and output the failure flag indicating the result of the failure diagnosis. Meanwhile, if the physical quantity detection element is temporarily brought into an abnormal state due to application of mechanical impact, vibration, or the like and an abnormal signal is input, there is a possibility that the signals output from the plurality of amplifiers may change and that the failure flag indicating a failure may be output, but in this case, the failure flag is disabled based on the mask signal. Therefore, according to the physical quantity detection circuit, it is possible to reduce the possibility of erroneously diagnosing that a failure has occurred if an abnormal signal generated by resonance or the like of the physical quantity detection element is input.

In one aspect, in the physical quantity detection circuit, the plurality of amplifiers may include a first amplifier that amplifies a first signal output from a first detection electrode of the physical quantity detection element, a second amplifier that amplifies a second signal output from a second detection electrode of the physical quantity detection element, and a third amplifier that amplifies a difference between the signal output from the first amplifier and the signal output from the second amplifier.

In one aspect, in the physical quantity detection circuit, the failure diagnosis signal output circuit may include an adder circuit that outputs a signal obtained by adding the signal output from the first amplifier to the signal output from the second amplifier, and a synchronous detection circuit that performs synchronous detection on the signal output from the adder circuit, and may output the failure diagnosis signal based on a signal output from the synchronous detection circuit.

In one aspect, in the physical quantity detection circuit, the mask signal output circuit may include a first comparator that compares a level of the signal output from the first amplifier with a set first detection level and outputs a first comparison result signal indicating a result of the comparison by the first comparator, a second comparator that compares a level of the signal output from the second amplifier with a set second detection level and outputs a second comparison result signal indicating a result of the comparison by the second comparator, a third comparator that compares a level of a signal output from the third amplifier with a set third detection level and outputs a third comparison result signal indicating a result of the comparison by the third comparator, and a fourth comparator that compares a level of the signal output from the adder circuit with a set fourth detection level and outputs a fourth comparison result signal indicating a result of the comparison by the fourth comparator, and a logic circuit that outputs the mask signal based on the first comparison result signal, the second comparison result signal, the third comparison result signal, and the fourth comparison result signal.

In one aspect, in the physical quantity detection circuit, a rising edge of the mask signal may be earlier than a rising edge of the failure flag, and a falling edge of the mask signal may be later than a falling edge of the failure flag.

According to the physical quantity detection circuit, if an abnormal signal is input, an entire period of time when the failure flag indicating a failure is output is included in a period of time when the mask signal indicating that the failure flag is to be disabled is output, and thus it is possible to reliably disable the failure flag.

In one aspect, in the physical quantity detection circuit, when the first comparison result signal is at a high level, the second comparison result signal is at a high level, the third comparison result signal is at a low level, and the fourth comparison result signal is at a high level, or when the first comparison result signal is at a low level, the second comparison result signal is at a low level, the third comparison result signal is at a low level, and the fourth comparison result signal is at a high level, or when the first comparison result signal is at a high level, the second comparison result signal is at a high level, and the third comparison result signal is at a high level, the mask signal output circuit may output the mask signal indicating that the failure flag is to be disabled.

According to the physical quantity detection circuit, it is possible to disable the failure flag when the physical quantity detection element temporarily resonates due to application of mechanical impact, vibration, or the like and an in-phase or differential resonance signal is input. Therefore, it is possible to reduce the possibility of erroneously diagnosing that a failure has occurred.

In one aspect, in the physical quantity detection circuit, the first signal may include a first physical quantity component and a first electrostatic leakage component propagated to the first detection electrode through a first electrostatic coupling capacitance present between a drive electrode of the physical quantity detection element and the first detection electrode, the second signal may include a second physical quantity component having a phase opposite to a phase of the first physical quantity component, and a second electrostatic leakage component having the same phase as the first electrostatic leakage component and propagated to the second detection electrode through a second electrostatic coupling capacitance present between the drive electrode of the physical quantity detection element and the second detection electrode, the physical quantity detection signal output circuit may perform, based on a first detection signal, synchronous detection on a signal output from the third amplifier and output the physical quantity detection signal based on a signal obtained by the synchronous detection performed by the physical quantity detection signal output circuit, the failure diagnosis signal output circuit may perform, based on a second detection signal, synchronous detection on a signal obtained by adding the signal output from the first amplifier to the signal output from the second amplifier and output the failure diagnosis signal based on a signal obtained by the synchronous detection performed by the failure diagnosis signal output circuit, and a frequency of the second detection signal may be twice a frequency of the first detection signal.

In the physical quantity detection circuit, since the first physical quantity component included in the first signal and the second physical quantity component included in the second signal have the opposite phases, the physical quantity components are amplified by the third amplifier and attenuated by the adder circuit. Therefore, according to the physical quantity detection circuit, it is possible to accurately generate the physical quantity detection signal, and to reduce the possibility that the accuracy of the failure diagnosis signal may decrease due to the physical quantity components.

In addition, in the physical quantity detection circuit, since the first electrostatic leakage component included in the first signal and the second electrostatic leakage component included in the second signal have the same phase, the electrostatic leakage components are amplified by the adder circuit and attenuated by the third amplifier. Therefore, according to the physical quantity detection circuit, it is possible to accurately generate the failure diagnosis signal, and to reduce the possibility that the accuracy of the physical quantity detection signal may decrease due to the electrostatic leakage components.

In one aspect, in the physical quantity detection circuit, the first signal may include a first physical quantity component, and further include a first vibration leakage component based on vibration of the physical quantity detection element if the physical quantity detection element fails, the second signal may include a second physical quantity component having a phase opposite to a phase of the first physical quantity component, and further include a second vibration leakage component having the same phase as the first vibration leakage component and based on vibration of the physical quantity detection element if the physical quantity detection element fails, the physical quantity detection signal output circuit may perform, based on a first detection signal, synchronous detection on a signal output from the third amplifier and output the physical quantity detection signal based on a signal obtained by the synchronous detection performed by the physical quantity detection signal output circuit, the failure diagnosis signal output circuit may perform, based on a third detection signal, synchronous detection on a signal obtained by adding the signal output from the first amplifier to the signal output from the second amplifier and output the failure diagnosis signal based on a signal obtained by the synchronous detection performed by the failure diagnosis signal output circuit, and a phase of the third detection signal may be shifted by 90° from a phase of the first detection signal.

In the physical quantity detection circuit, since the first physical quantity component included in the first signal and the second physical quantity component included in the second signal have the opposite phases, the physical quantity components are amplified by the third amplifier and attenuated by the adder circuit. Therefore, according to the physical quantity detection circuit, it is possible to accurately generate the physical quantity detection signal, and to reduce the possibility that the accuracy of the failure diagnosis signal may decrease due to the physical quantity components.

In addition, in the physical quantity detection circuit, since the first vibration leakage component included in the first signal and the second vibration leakage component included in the second signal have the same phase, the vibration leakage components are amplified by the adder circuit and attenuated by the third amplifier. Therefore, according to the physical quantity detection circuit, it is possible to accurately generate the failure diagnosis signal, and to reduce the possibility that the accuracy of the physical quantity detection signal may decrease due to the vibration leakage components.

In another aspect, a physical quantity detection device includes a semiconductor device including the physical quantity detection circuit according to any one of the aspects, the physical quantity detection element, and a package housing the physical quantity detection element and the semiconductor device.

In the physical quantity detection device, since the failure diagnosis signal changes if a failure such as decoupling occurs in wiring coupling the physical quantity detection element and the physical quantity detection circuit, the failure diagnosis circuit can perform the failure diagnosis based on the failure diagnosis signal and output the failure flag indicating the result of the failure diagnosis. Meanwhile, if the physical quantity detection element is temporarily brought into an abnormal state due to application of mechanical impact, vibration, or the like, and an abnormal signal is input to the physical quantity detection circuit, there is a possibility that a failure flag indicating a failure may be output, but in this case, the failure flag is disabled based on the mask signal. Therefore, according to the physical quantity detection device, it is possible to reduce the possibility of erroneously diagnosing that a failure has occurred when an abnormal signal generated due to resonance or the like of the physical quantity detection element is input.

In one aspect, in the physical quantity detection device, the physical quantity detection element may be a double-T type gyro sensor element.

## Claims

1. A physical quantity detection circuit comprising:
a physical quantity detection signal output circuit that includes an amplifier circuit that amplifies a signal output from a physical quantity detection element that detects a physical quantity, and outputs a physical quantity detection signal corresponding to the physical quantity;
a failure diagnosis signal output circuit that outputs a failure diagnosis signal based on a signal output from at least one of a plurality of amplifiers included in the amplifier circuit;
a failure diagnosis circuit that performs failure diagnosis based on the failure diagnosis signal and outputs a failure flag indicating a result of the failure diagnosis;
a mask signal output circuit that compares a level of a signal output from each of the plurality of amplifiers with each of a plurality of set detection levels and outputs a mask signal based on a result of the comparison; and
a disabling determination circuit that disables the failure flag based on the mask signal.

2. The physical quantity detection circuit according to claim 1, wherein
the plurality of amplifiers include
a first amplifier that amplifies a first signal output from a first detection electrode of the physical quantity detection element,
a second amplifier that amplifies a second signal output from a second detection electrode of the physical quantity detection element, and
a third amplifier that amplifies a difference between a signal output from the first amplifier and a signal output from the second amplifier.

3. The physical quantity detection circuit according to claim 2, wherein
the failure diagnosis signal output circuit includes
an adder circuit that outputs a signal obtained by adding the signal output from the first amplifier to the signal output from the second amplifier, and
a synchronous detection circuit that performs synchronous detection on the signal output from the adder circuit, and
the failure diagnosis signal output circuit outputs the failure diagnosis signal based on a signal output from the synchronous detection circuit.

4. The physical quantity detection circuit according to claim 3, wherein
the mask signal output circuit includes
a first comparator that compares a level of the signal output from the first amplifier with a set first detection level and outputs a first comparison result signal indicating a result of the comparison by the first comparator,
a second comparator that compares a level of the signal output from the second amplifier with a set second detection level and outputs a second comparison result signal indicating a result of the comparison by the second comparator,
a third comparator that compares a level of a signal output from the third amplifier with a set third detection level and outputs a third comparison result signal indicating a result of the comparison by the third comparator,
a fourth comparator that compares a level of the signal output from the adder circuit with a set fourth detection level and outputs a fourth comparison result signal indicating a result of the comparison by the fourth comparator, and
a logic circuit that outputs the mask signal based on the first comparison result signal, the second comparison result signal, the third comparison result signal, and the fourth comparison result signal.

5. The physical quantity detection circuit according to claim 1, wherein
a rising edge of the mask signal is earlier than a rising edge of the failure flag, and a falling edge of the mask signal is later than a falling edge of the failure flag.

6. The physical quantity detection circuit according to claim 4, wherein
when the first comparison result signal is at a high level, the second comparison result signal is at a high level, the third comparison result signal is at a low level, and the fourth comparison result signal is at a high level, or
when the first comparison result signal is at a low level, the second comparison result signal is at a low level, the third comparison result signal is at a low level, and the fourth comparison result signal is at a high level, or
when the first comparison result signal is at a high level, the second comparison result signal is at a high level, and the third comparison result signal is at a high level,
the mask signal output circuit outputs the mask signal indicating that the failure flag is to be disabled.

7. The physical quantity detection circuit according to claim 2, wherein
the first signal includes a first physical quantity component and a first electrostatic leakage component propagated to the first detection electrode through a first electrostatic coupling capacitance present between a drive electrode of the physical quantity detection element and the first detection electrode,
the second signal includes a second physical quantity component having a phase opposite to a phase of the first physical quantity component, and a second electrostatic leakage component having a same phase as the first electrostatic leakage component and propagated to the second detection electrode through a second electrostatic coupling capacitance present between the drive electrode of the physical quantity detection element and the second detection electrode,
the physical quantity detection signal output circuit performs, based on a first detection signal, synchronous detection on a signal output from the third amplifier and outputs the physical quantity detection signal based on a signal obtained by the synchronous detection performed by the physical quantity detection signal output circuit,
the failure diagnosis signal output circuit performs, based on a second detection signal, synchronous detection on a signal obtained by adding the signal output from the first amplifier to the signal output from the second amplifier and outputs the failure diagnosis signal based on a signal obtained by the synchronous detection performed by the failure diagnosis signal output circuit, and
a frequency of the second detection signal is twice a frequency of the first detection signal.

8. The physical quantity detection circuit according to claim 2, wherein
the first signal includes a first physical quantity component, and further includes a first vibration leakage component based on vibration of the physical quantity detection element if the physical quantity detection element fails,
the second signal includes a second physical quantity component having a phase opposite to a phase of the first physical quantity component, and further includes a second vibration leakage component having a same phase as the first vibration leakage component and based on vibration of the physical quantity detection element if the physical quantity detection element fails,
the physical quantity detection signal output circuit performs, based on a first detection signal, synchronous detection on a signal output from the third amplifier and outputs the physical quantity detection signal based on a signal obtained by the synchronous detection performed by the physical quantity detection signal,
the failure diagnosis signal output circuit performs, based on a third detection signal, synchronous detection on a signal obtained by adding the signal output from the first amplifier to the signal output from the second amplifier and outputs the failure diagnosis signal based on a signal obtained by the synchronous detection performed by the failure diagnosis signal output circuit, and
a phase of the third detection signal is shifted by 90° from a phase of the first detection signal.

9. A physical quantity detection device comprising:
a semiconductor device including the physical quantity detection circuit according to claim 1;
the physical quantity detection element; and
a package housing the physical quantity detection element and the semiconductor device.

10. The physical quantity detection device according to claim 9, wherein
the physical quantity detection element is a double-T type gyro sensor element.
